# EUROPEAN PATENT SPECIFICATION

(11) **EP 2 951 499 B1**
(45) Date of publication and mention of the grant of the patent: **26.05.2021**
(21) Application number: 14745608.1
(22) Date of filing: 30.01.2014
(51) Int. Cl.: F21V 8/00, F21V 21/112, F21S 8/06, F21S 8/04, F21V 5/00, F21V 7/00, F21K 9/23, F21K 9/61, F21Y 115/10, F21Y 107/30, F21V 23/04

(54) **OPTICAL WAVEGUIDE BODIES**
LICHTLEITKÖRPER
CORPS DE GUIDES D'ONDES OPTIQUES

(30) Priority: 30.01.2013 US 201361758660 P; 15.03.2013 US 201313842521; 15.03.2013 US 201313839949; 15.03.2013 US 201313841074; 15.03.2013 US 201313840563; 10.07.2013 US 201313938877; 09.12.2013 US 201314101086; 09.12.2013 US 201314101099; 09.12.2013 US 201314101129; 09.12.2013 US 201314101051; 09.12.2013 US 201314101132; 09.12.2013 US 201314101147; 30.12.2013 US 201361922017 P
(43) Date of publication of application: 09.12.2015
(73) Proprietor: IDEAL INDUSTRIES LIGHTING LLC, Durham, NC 22703 (US)
(72) Inventor: WILCOX, Kurt, S., Libertyville, IL 60048 (US); DURKEE, John, W., Raleigh, NC 27604 (US); TARSA, Eric, J., Goleta, CA 93117 (US)
(74) Representative: Boult Wade Tennant LLP
(86) International application number: PCT/US2014/013937
(87) International publication number: WO 2014/120971

(56) References cited:
- WO-A1-2012/073156
- US-A1- 2004 076 010
- US-A1- 2006 076 568
- US-A1- 2011 013 420
- US-A1- 2011 248 287
- US-A1- 2011 261 570
- US-A1- 2012 020 108
- US-A1- 2012 113 676
- US-A1- 2012 140 461
- US-A1- 2012 188 774
- US-B1- 6 193 383
- US-B2- 6 598 998

## Description

### TECHNICAL FIELD

The present inventive subject matter relates to luminaires, and more particularly to luminaires utilizing optical waveguides for general lighting.

### BACKGROUND ART

An optical waveguide mixes and directs light emitted by one or more light sources, such as one or more light emitting diodes (LEDs). A typical optical waveguide includes three main components: one or more coupling elements, one or more distribution elements, and one or more extraction elements. The coupling component(s) direct light into the distribution element(s), and condition the light to interact with the subsequent components. The one or more distribution elements control how light flows through the waveguide and are dependent on the waveguide geometry and material. The extraction element(s) determine how light is removed by controlling where and in what direction the light exits the waveguide.

When designing coupling component(s), the primary considerations are: maximizing the efficiency of light transfer from the source into the waveguide; controlling the location of light injected into the waveguide; and controlling the angular distribution of the light in the coupling optic. Light may be coupled into the waveguide through an air gap and a coupling cavity defined by surfaces located at an edge and/or interior portions of the waveguide. Such surfaces comprise an interface between the relatively low index of refraction of air and the relatively high index of refraction of the waveguide material. A way of controlling the spatial and angular spread of injected light is by fitting each source with a dedicated lens. These lenses can be disposed with an air gap between the lens and the coupling optic, or may be manufactured from the same piece of material that defines the waveguide's distribution element(s).

After light has been coupled into the waveguide, it must be guided and conditioned to the locations of extraction. The simplest example is a fiber-optic cable, which is designed to transport light from one end of the cable to another with minimal loss in between. To achieve this, fiber optic cables are only gradually curved and sharp bends in the waveguide are avoided. In accordance with well-known principles of total internal reflectance light traveling through a waveguide is reflected back into the waveguide from an outer surface thereof, provided that the incident light does not exceed a critical angle with respect to the surface.

In order for an extraction element to remove light from the waveguide, the light must first contact the feature comprising the element. By appropriately shaping the waveguide surfaces, one can control the flow of light across the extraction feature(s). Specifically, selecting the spacing, shape, and other characteristic(s) of the extraction features affects the appearance of the waveguide, its resulting distribution, and efficiency.

Hulse U.S. Patent No. 5,812,714 discloses a waveguide bend element configured to change a direction of travel of light from a first direction to a second direction. The waveguide bend element includes a collector element that collects light emitted from a light source and directs the light into an input face of the waveguide bend element. Light entering the bend element is reflected internally along an outer surface and exits the element at an output face. The outer surface comprises beveled angular surfaces or a curved surface oriented such that most of the light entering the bend element is internally reflected until the light reaches the output face

Parker et al. U.S. Patent No. 5,613,751 discloses a light emitting panel assembly that comprises a transparent light emitting panel having a light input surface, a light transition area, and one or more light sources. Light sources are preferably embedded or bonded in the light transition area to eliminate any air gaps, thus reducing light loss and maximizing the emitted light. The light transition area may include reflective and/or refractive surfaces around and behind each light source to reflect and/or refract and focus the light more efficiently through the light transition area into the light input surface of the light-emitting panel. A pattern of light extracting deformities, or any change in the shape or geometry of the panel surface, and/or coating that causes a portion of the light to be emitted, may be provided on one or both sides of the panel members. A variable pattern of deformities may break up the light rays such that the internal angle of reflection of a portion of the light rays will be great enough to cause the light rays either to be emitted out of the panel or reflected back through the panel and emitted out of the other side.

Shipman, U.S. Patent No. 3,532,871 discloses a combination running light reflector having two light sources, each of which, when illuminated, develops light that is directed onto a polished surface of a projection. The light is reflected onto a cone-shaped reflector. The light is transversely reflected into a main body and impinges on prisms that direct the light out of the main body.

Simon U.S. Patent No. 5,897,201 discloses various embodiments of architectural lighting that is distributed from contained radially collimated light. A quasi-point source develops light that is collimated in a radially outward direction and exit means of distribution optics direct the collimated light out of the optics.

A.L.P. Lighting Components, Inc. of Niles, Illinois, manufactures a waveguide having a wedge shape with a thick end, a narrow end, and two main faces therebetween. Pyramid-shaped extraction features are formed on both main faces. The wedge waveguide is used as an exit sign such that the thick end of the sign is positioned adjacent a ceiling and the narrow end extends downwardly. Light enters the waveguide at the thick end and is directed down and away from the waveguide by the pyramid-shaped extraction features.

Low-profile LED-based luminaires have recently been developed (e.g., General Electric's ET series panel troffers) that utilize a string of LED components directed into the edge of a waveguiding element (an "edge-lit" approach). However, such luminaires typically suffer from low efficiency due to losses inherent in coupling light emitted from a predominantly Lambertian emitting source such as an LED component into the narrow edge of a waveguide plane.
Document WO 2012/073156 A1 relates to an LED-based optical unit including an LED disposed on a surface and a monolithic module encompassing the LED and including a re-directing portion and a first diffusing portion. The first diffusing portion is configured to diffuse light incident thereon. The re-directing portion is configured to re-direct at least a first portion of light emitted by the LED to be incident on the first diffusing portion. The rays are extracted out of the top of the monolithic module.
Document US 6,193,383 B1 discloses an elongated transparent light leading member which is provided above a light source. The leading member is provided opposite to the light source. A hole is formed in the light leading member at a position above the light source. The hole has an inverted triangular shape, opposite sides of the hole are provided for reflecting light beams emitted from the light source in a longitudinal direction of the light leading member. Lower surfaces of the leading member are covered by reflecting surfaces.

### SUMMARY

The invention provides a waveguide body as defined by claim 1.

### BRIEF DESCRIPTION OF THE DRAWINGS

Figure 1 is an isometric view showing a disclosed luminaire.
Figure 2 is a combined end elevation view and block diagram of the luminaire of Figure 1.
Figure 2A is an exploded isometric view of the luminaire of Figures 1 and 2.
Figure 3 is an enlarged, fragmentary side elevational view of the central section as referenced by the view lines 3-3 of Figure 2.
Figure 3A is an enlarged, fragmentary side elevation of a central section.
Figure 3B is an enlarged, fragmentary side elevation of a luminaire that generates two independent light beams.
Figure 4 is an enlarged, fragmentary side elevational view of an extraction feature as referenced by the view line 4-4 of Figure 2.
Figure 4A is a graph illustrating a desired light distribution emitted from the luminaire of Figures 1 and 2.
Figure 4B is fragmentary view of an extraction feature used in one embodiment of the disclosure.
Figure 4C is a fragmentary view of an extraction feature used in a second embodiment of the disclosure.
Figure 4D is a fragmentary isometric view of a waveguide surface showing a particular embodiment of extraction features extending outwardly from the surface of the waveguide.
Figure 4E is fragmentary view of an extraction feature used in a further embodiment of the disclosure.
Figure 4F is an enlarged, fragmentary, cross sectional view of the extraction feature of Figure 4E.
Figure 4G is a fragmentary view of an extraction feature used in a further embodiment of the disclosure.
Figure 4H is an enlarged plan view of the extraction feature of Figure 4G.
Figure 4I is an enlarged, fragmentary, cross sectional view of the extraction feature of Figure 4G.
Figure 4J is a graph illustrating an alternative desired light distribution emitted from the luminaire of Figures 1 and 2.
Figure 5A is a perspective of a further luminaire.
Figure 5B is an end elevational view of a luminaire that is a modified version of that shown in Figure 5A with an end cap removed.
Figure 5C is an enlarged, fragmentary side elevational view of the central section of the waveguide body of Figure 5B.
Figure 6 is an enlarged, fragmentary cross-sectional view of a central section of any of the waveguide bodies described herein showing a light source located proximal the central section and a mirrored top reflector opposite the light source.
Figure 6A is an enlarged, fragmentary end view of a central section showing a specular reflective body located in the V-shaped convergence between the first and second sides of the waveguide body.
Figure 7 is a diagram showing light rays traveling through a waveguide body having facets disposed at a first angle.
Figure 8 is a diagram showing light rays traveling through a waveguide having facets disposed a second angle shallower than the facets of Figure 7.
Figure 9 is a diagram showing light rays traveling through the waveguide body in another disclosed luminaire.
Figure 10 is side elevational view of a waveguide used in yet another disclosed luminaire.
Figure 11 is an end elevational view of a waveguide body usable in a still further luminaire.
Figure 12 is an isometric view of the waveguide body of Figure 11.
Figure 13A is an end elevational view of another waveguide body usable in yet another disclosed luminaire.
Figure 13B is an isometric view of the waveguide body of Figure 13A.
Figure 14A is an end elevational view of a waveguide body usable in a still further luminaire.
Figure 14B is an isometric view of the waveguide body of Figure 14A.
Figure 15A is an end elevational view of a waveguide body usable in another luminaire.
Figure 15B is an isometric view of the waveguide body of Figure 15A.
Figure 16A is an isometric view of yet another waveguide body usable in a still further luminaire.
Figure 16B is an isometric view of a still further waveguide body usable in another luminaire.
Figure 17A is an isometric view of yet another waveguide body usable in a still further luminaire.
Figure 17B is an isometric view of a still further waveguide body usable in another luminaire.
Figure 18A is an isometric view of yet another waveguide body usable in a still further luminaire.
Figure 18B is an isometric view of a still further waveguide body usable in another luminaire.
Figure 19A is an isometric view of yet another waveguide body usable in a still further luminaire.
Figure 19B is an isometric view of a still further waveguide body usable in another luminaire.
Figure 20 is an end view of a luminaire.
Figure 21 is a side elevation view of an embodiment of a central section of a waveguide disclosed in the application.
Figure 22A is a fragmentary isometric of an embodiment of extraction features used in conjunction with the waveguide disclosed in the application.
Figure 22B is a fragmentary isometric of a second embodiment of extraction features used in conjunction with the waveguide disclosed in the application.
Figure 22C is a fragmentary isometric of still another embodiment of extraction features used in conjunction with the waveguide disclosed in the application.
Figure 22D is an enlarged, fragmentary, cross sectional view of a further embodiment of extraction features used in conjunction with the waveguide disclosed in the application.
Figure 23A is an isometric view of yet another waveguide body usable in a further luminaire.
Figure 23B is a second isometric view of the waveguide body shown in Figure 23A.
Figure 23C is a side elevation of the waveguide body shown in Figure 23A.
Figure 24A is a lower elevation view of still another disclosed luminaire.
Figure 24B is a sectional view of the luminaire shown in Figure 24A.
Figure 24C is an isometric view of the luminaire shown in Figure 24A.
Figure 25A is a lower elevation view of yet another disclosed luminaire.
Figure 25B is a side elevation of the luminaire shown in Figure 25A.
Figure 25C is a side elevation of one of the components of the luminaire shown in Figure 25A.
Figure 25D is an isometric view showing in dash lines the outline of one of the components of the luminaire shown in Figure 25A and in solid line the cross section of the component.
Figure 26 is a side elevation view of an embodiment of a central section of a waveguide disclosed in the application showing a textured surface opposite the input surface.
Figure 27 is a side elevation view of a luminaire disclosed in the application and a reflector opposite one side of the luminaire.
Figure 27A is a graph illustrating an alternative desired light distribution emitted from the luminaire of Figures 27.
Figure 28 is a side elevation view of a waveguide body that does not form part of the invention.
Figure 28A is an exploded isometric view of the device of Figure 28.
Figure 29 is a side elevation view of another embodiment of a waveguide body.
Figure 30 is a further embodiment of a waveguide used in yet another disclosed luminaire.
Figure 30A is a side elevation view of a central section of the embodiment of Figure 30.

### DETAILED DESCRIPTION

The following examples further illustrate the invention but, of course, should not be construed as in any way limiting its scope.

In general, the curvature and/or other shape of a waveguide body and/or the shape, size, and/or spacing of extraction features determine the particular light extraction distribution. All of these options affect the visual uniformity from one end of the waveguide to another. For example, a waveguide body having smooth surfaces may emit light at curved portions thereof. The sharper the curve is the more light is extracted. The extraction of light along a curve also depends on the thickness of the waveguide body. Light can travel through tight curves of a thin waveguide body without reaching the critical angle, whereas light that travels through a thick waveguide body is more likely to strike the surface at an angle lower than the critical angle and escape.

Tapering a waveguide body causes light to reflect internally along the length of the waveguide body while increasing the angle of incidence. Eventually, this light strikes one side at an angle that is acute enough to escape. The opposite example, i.e., a gradually thickening waveguide body over the length thereof, causes light to collimate along the length with fewer and fewer interactions with the waveguide body surfaces. These interactions can be used to extract and control light within the waveguide. When combined with dedicated extraction features, tapering allows one to change the incident angular distribution across an array of features. This, in turn, controls how much, and in what direction light is extracted. Thus, a select combination of curves, tapered surfaces, and extraction features can achieve a desired illumination and appearance.

Still further, the waveguide bodies contemplated herein are made of any suitable optically transmissive material, such as an acrylic material, a silicone, a polycarbonate, a glass material, a cyclic olefin copolymer, air, or other suitable material(s), or combinations thereof to achieve a desired effect and/or appearance.

According to one aspect, a waveguide directs light into at least one up to an infinite number of beams or ray groups, wherein the rays of each group travel through the waveguide within a range of angles relative to one another. Each range may be narrow or broad within the TIR limits of the waveguide material.

According to another aspect, a waveguide arranges light into a plurality of groups that bounce at least once inside the waveguide by total internal reflection ("TIR") off one or more surfaces of the waveguide. Each group comprises a plurality of light rays that travel at angles that are disposed within a narrow or broad range of angles relative to one another.

In any embodiment, the range may be so narrow that the light rays of the ray group may be considered to be fully collimated, or nearly so, or the range may be so broad that the light rays of a ray group may be considered to be anti-collimated, or nearly so. Controlling the ray angles in this manner can lead to increased light control, reduced waveguide size and weight, and reduced luminaire costs.

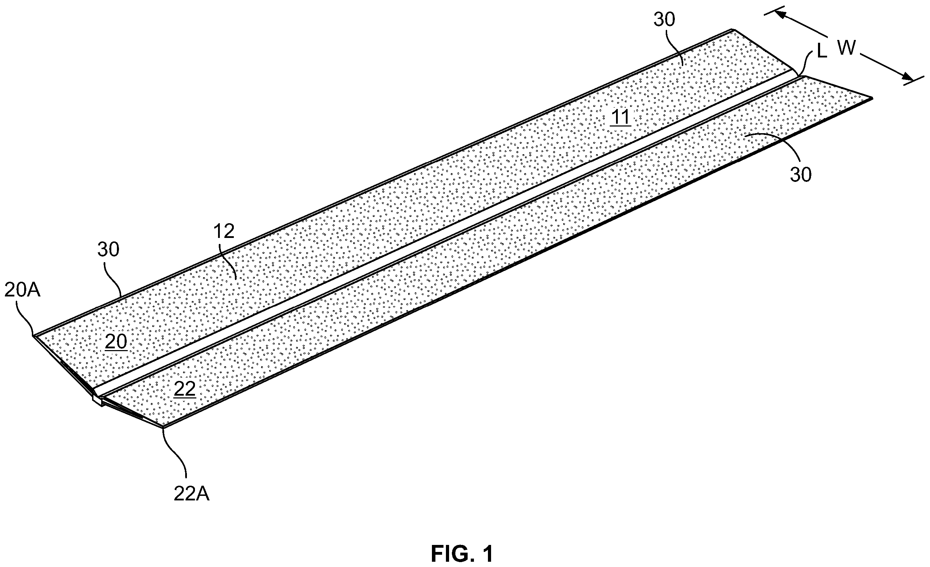

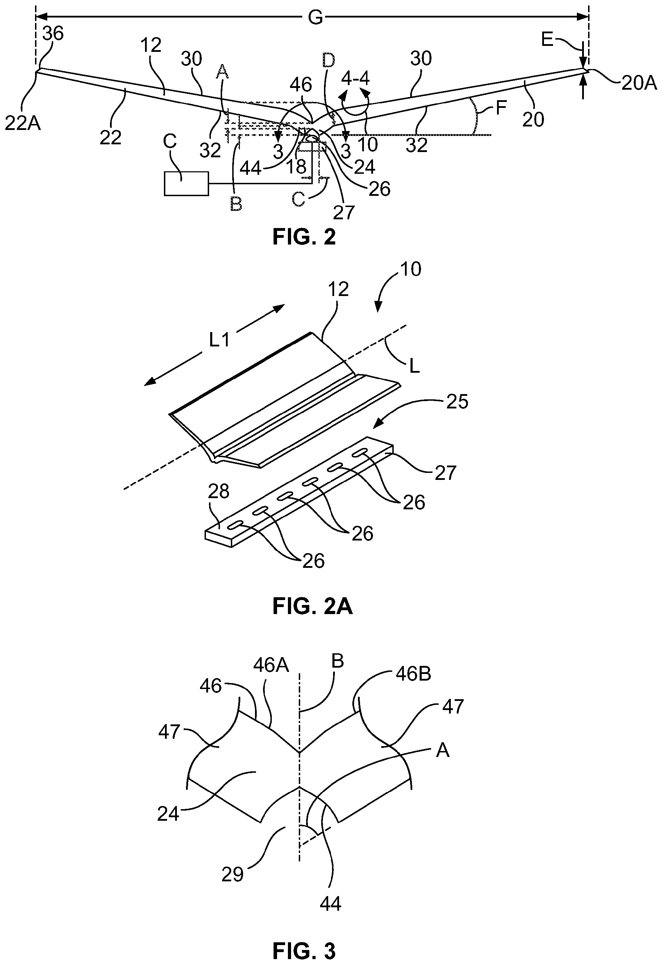

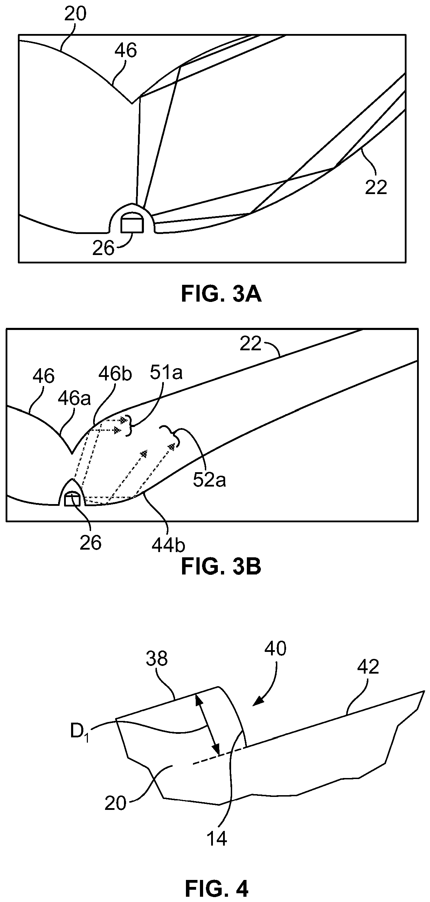

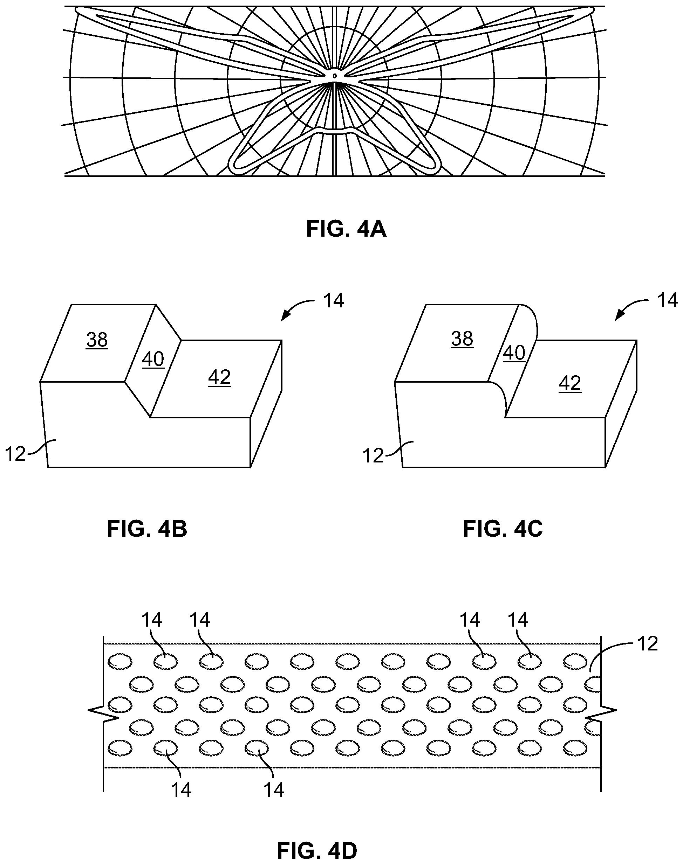

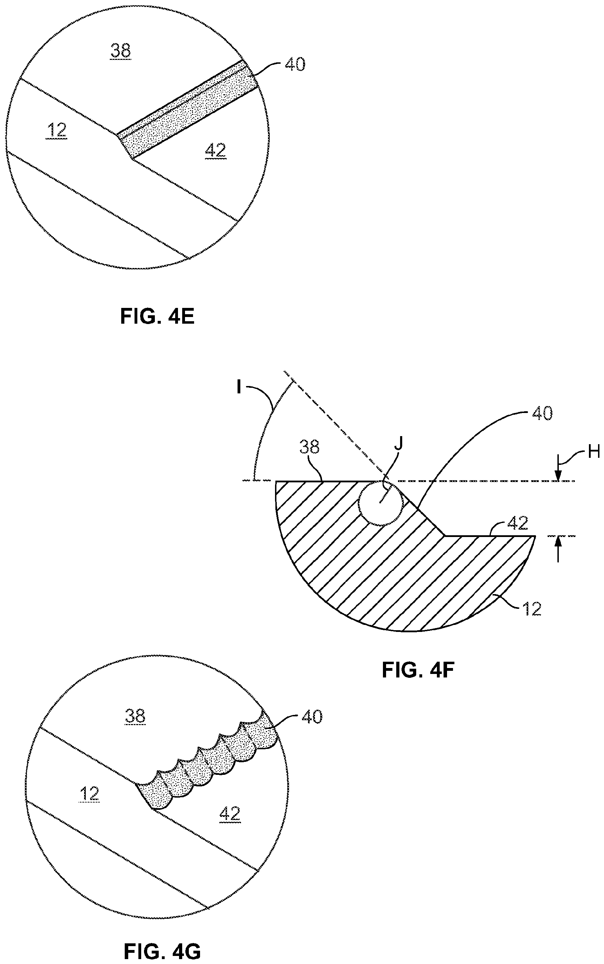

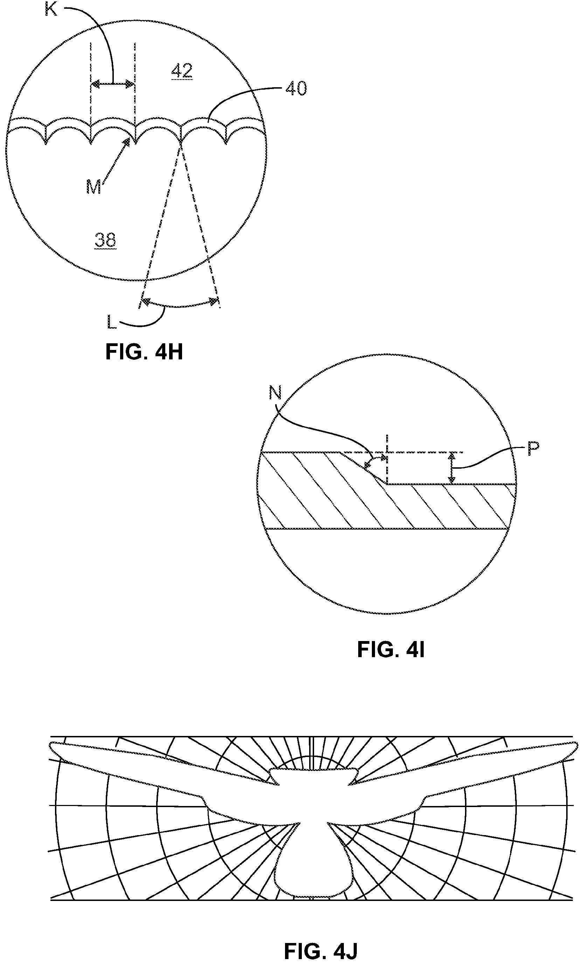

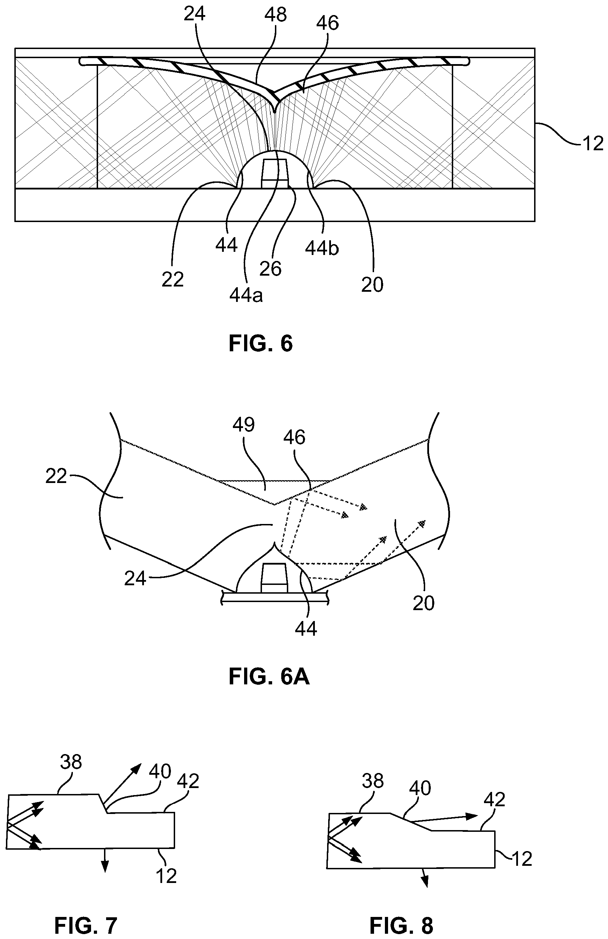

Figures 1-3 show a luminaire 10 comprising a waveguide having a waveguide body 12 including a central section 18 and first and second separate side sections 20, 22 extending away from the central section 18 along first and second directions, respectively, and terminating at first and second outer ends 20A, 22A, respectively (Figure 2). The side sections 20, 22 in the illustrated device are preferably mirror images of one another. The central section 18 includes a coupling portion 24, and a light source 25 in the form of one or more LED element(s) 26, are disposed adjacent the coupling portion 24, as shown in Figure 2, and the light source 25 is adapted to produce light that is directed into the waveguide body 12 via the coupling portion 24. A power circuit C (Figure 2) provides power to the light source 25, and the waveguide body 12 includes a plurality of light extraction features 14 (Figures 4, 4B, 4C, 4D, 4E, and 4G show various embodiments of such features 14) that extract light out of the side sections 20, 22, for example as shown in Figures 7 and 8.

More specifically, as seen in FIG. 2A, the luminaire 10 includes a base element in the form of a substrate 27 having a base surface 28. If desired, the base surface 28 may be covered or coated by a reflective material, which may be a white material or a material that exhibits specular reflective characteristics. LED elements 26 are mounted on the base surface 28. The substrate 27 is secured in fixed relation to the waveguide body 12 in any suitable fashion such that the LED elements are preferably equally spaced along a longitudinal axis L (Figure 2A) and further extend into a cavity 29 (Figure 3) of the coupling portion 24. Each LED element 26 may be a single white LED or multiple white LEDs or each may comprise multiple LEDs either mounted separately or together on a single substrate or package including a phosphor-coated LED either alone or in combination with a color LED, such as a green LED, etc. In those cases where a soft white illumination is to be produced, each LED element 26 typically includes one or more blue-shifted yellow LEDs and one or more red LEDs. Different color temperatures and appearances could be produced using other LED combinations, as is known in the art. In one case, the light source comprises any LED, for example, an MT-G LED module incorporating TrueWhite® LED technology or as disclosed in U.S. Patent 9,818,919 B2, filed October 10, 2012 entitled "LED Package with Multiple Element Light Source and Encapsulant Having Planar Surfaces" by Lowes et al. In any of the luminaires disclosed herein the LED(s) have a particular emission distribution, as necessary or desirable. For example, a side emitting LED disclosed in U.S. Patent No. 8,541,795 may be utilized inside the waveguide body. More generally, any Lambertian, symmetric, wide angle, preferential-sided, or asymmetric beam pattern LED(s) may be used as the light source. Still further, any of the LED arrangements and optical elements disclosed in co-pending U.S. Patent 9,869,432 B2, filed December 9, 2013, entitled "Luminaires Using Waveguide Bodies and Optical Elements" by Keller et al. may be used.

The power circuit C may be disposed on the substrate 27 or may be located remotely, or a portion of the power circuit C may be disposed on the substrate and the remainder of the power circuit C may be remotely located. In any event, the power circuit C is designed to operate the light source 25 with AC or DC power in a desired fashion to produce light of a desired intensity and appearance. If necessary or desirable, a heat exchanger (not shown) is arranged to dissipate heat and eliminate thermal crosstalk between the LEDs and the power circuit C. Preferably, the light source 25 develops light appropriate for general illumination purposes including light that may be generated in a down light, a light that produces a wall washing effect, a task light, a troffer, or the like.

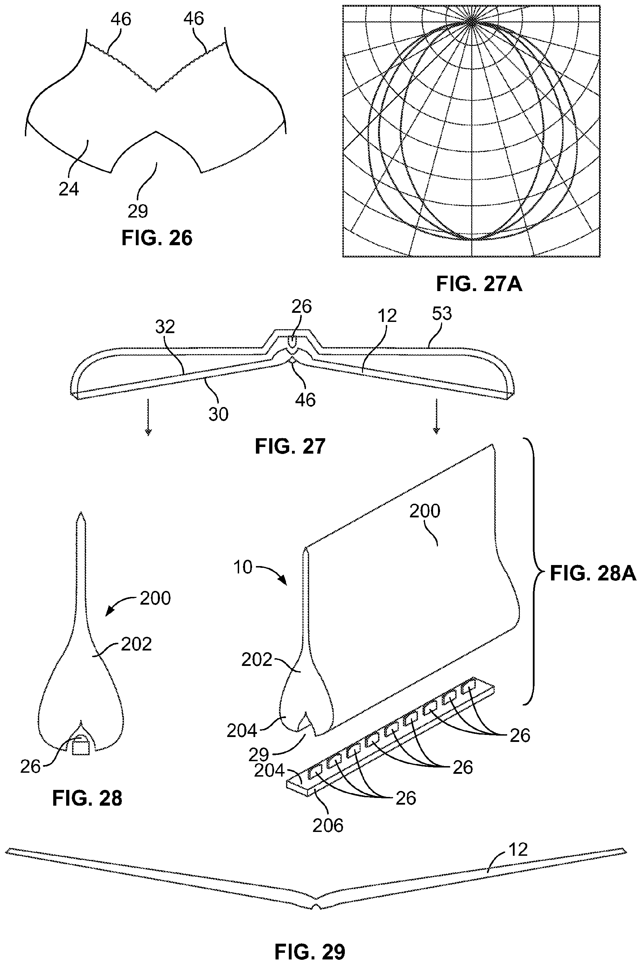

In Figures 1-3 each of the first and the second side sections 20, 22 has an upper and a lower surface 30, 32 and includes a first end 20B, 22B proximal to the coupling portion 24 and a second end 20A, 22A, respectively distal to the coupling portion 24. The first end 20B, 22B has a first thickness T₁, the second end 20A, 22A has a second thickness T₂, and the first thickness T₁ is greater than the second thickness T₂, and hence, the side sections 20, 22 are tapered. In a particular case, for example, the first thickness T₁ is no greater than about 6 millimeters and the second thickness is no less than about 2 millimeters. In one case, a center portion of each of the first and the second side sections 20, 22 also has a thickness equal to the second end 20A, 22A in that, for example, it is no less than about 2 millimeters. It should be noted that the minimum thickness is only limited by structural strength considerations, while maximum thickness is currently only limited by manufacturing considerations. In one case, the ratio of the maximum to minimum thickness of the waveguide body is 10:1 or less. In a more particular version of this case, the ratio is approximately 3:1. In a particular case, as shown in Figure 27, a reflector 53 may be placed above the upper surface 30 of the waveguide 12. If desired, the reflector 53 can be replaced by a specular or reflective coating disposed on the surface 30. (In the embodiment of Figure 27, the surface 32 is disposed above the surface 30, opposite to previous illustrated cases.) Figure 27A illustrates an example light distribution of the device of Figure 27, where the concentric circles mark the magnitude of intensity (candelas: lumens/steradian), and the lines extending radially from the center mark the angle of the exiting light with 0° pointing straight down, 90° to the right and 180° straight up. Other desired light distributions may be realized.

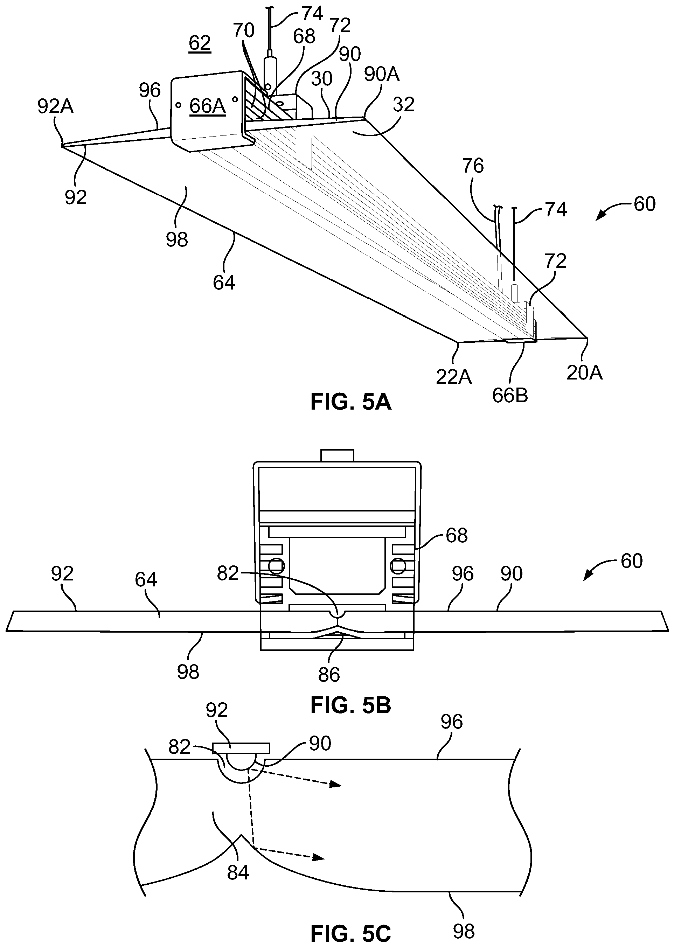

In still another case, a flat waveguide body 12 is used in which the first thickness T₁ is equal to the second thickness T₂, as shown in Figure 5B.

Also in Figures 1-3, the coupling portion 24 curves upward away from the LED elements 26 toward one or both of the second ends 20A, 22A. The upper surface 30 of the first and second sections 20, 22 may be textured. Each textured surface 30 may comprise a plurality of light extraction features 14, one of which is shown in Figure 4. In a more particular embodiment, each of the plurality of light extraction features 14 comprises an intermediate surface 40 that extends from a first surface 38 to a second surface 42. All or some of the intermediate surfaces 40 may be planar or curved, as shown in Figures 4, 4B, 4C, 4D, 4E, and 4G. In an embodiment, the angle of curvature of the intermediate surface 40 may range from 10° to 80°. In a more particular version of the embodiment, the angle of curvature is approximately 30° to 60°. In still another version of the embodiment, the angle of curvature of the intermediate surface 40 is approximately 42.5° to 50°. The intermediate surfaces 40 may, but need not, have a constant radius of curvature. Furthermore, the edges 47 of the coupling portion 24 can be of any shape including, but not limited to, planar curved, angled, tapered, etc.

Also preferably, each first surface 38 is displaced from an associated adjacent second surface 42 by a particular distance D1, as shown in Figure 4, wherein the distances D₁ are constant or vary along the length and width of each surface 30. The disposition of the center of the radius of curvature, the magnitude of the radius of curvature, and the arcuate extent of each intermediate surface 40 affect the distribution of light from the waveguide body 12. In another embodiment, as seen in Figures 7 and 8, the intermediate surfaces 40 are planar, and the intermediate surfaces 40 are all parallel to one another, although the surfaces 40 need not all be planar or parallel. In an embodiment, the perpendicular distance between the first surface 38 and the adjacent second surface 42 *(i.e.,* the length of a line extending from and normal to the surface 38 to an imaginary projection of the plane 42 below the surface 38) is preferably less than 100 microns, and more preferably between about 20 and about 100 microns. In another embodiment, the intermediate surfaces 40 are parallel to one another and are disposed at non-zero angles with respect to associated first and second surfaces 38, 42. . The angle between each intermediate surface 40 and a line tangent to an adjacent associated surface 38 or 42 where the surface 38 or 42 meets the surface 40 may be relatively steep (for example, as seen in Figure 7) or may be relatively shallow (e.g., as seen in Figure 8). Thus, for instance, the angle between each intermediate surface 40 and a line tangent to an adjacent associated surface 38 where the surface 38 meets the surface 40 may be in a range between about 5 degrees and 90 degrees, and more particularly, may be between about 40 degrees and about 60 degrees, and, most preferably, about 50 degrees. This angle (or any other related angle, such as the angle between the intermediate surface 40 and a line tangent to an adjacent associated surface 42 where the surface 42 meets the surface 40) and the size of each intermediate surface 40 affect the output distribution of light from the waveguide body 12.

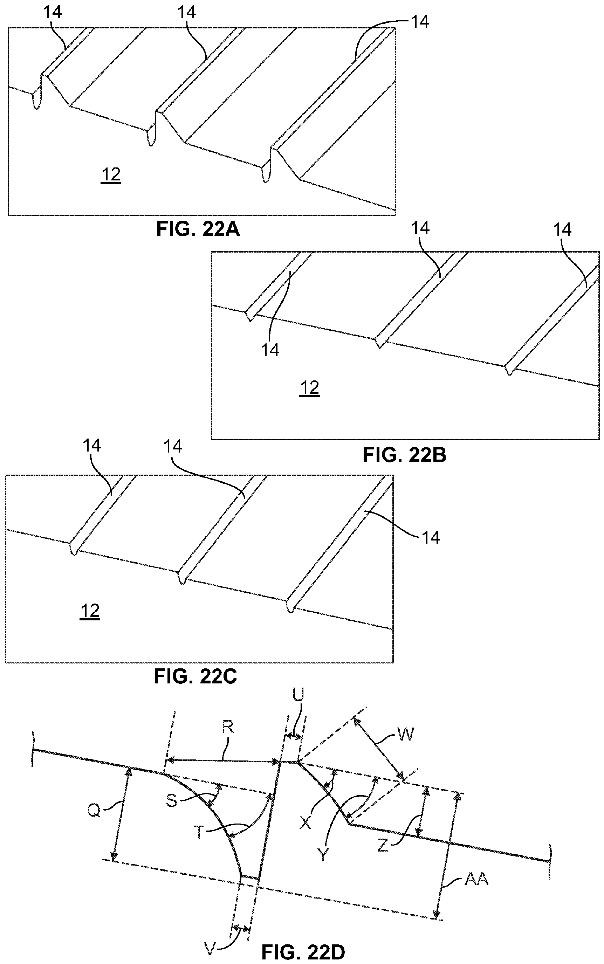

It should also be noted that the extraction features may be of differing size, shape, and/or spacing over the surface(s) of the waveguide body 12 so that an asymmetric emitted light distribution is obtained. For example, the extraction features may include a combined notch and step extraction that leads to a tapered edge, as shown in Figures 22A-22D. The extraction features shown in Figure 22D may have dimensions noted in the following table, although such dimensions are exemplary only and not limiting.

**Table 1**

| Figure 22D | NOMINAL DIMENSION (Millimeters - unless otherwise specified) |
|---|---|
| Q | 0.100 |
| R | 0.134 |
| S | 20 degrees |
| T | 65 degrees |
| U | 0.020 |
| V | 0.020 |
| W | 0.092 |
| X | 30 degrees |
| Y | 50 degrees |
| Z | 0.060 |
| AA | 0.140 |

Additionally, as seen in co-pending U.S. Patent Application No. 14/101,086, filed December 9, 2013, entitled "Optical Waveguides and Luminaires Incorporating Same" by Keller et al. (Cree docket no. P2126US1), the extraction features may comprise small indents or protrusions and a relatively large number of such extraction features may be disposed to the left of the coupling portion 24 and a relatively small number of such extraction features may be disposed to the right of the coupling portion 24. In such an embodiment, as should be evident, more light is extracted from the left side of the waveguide body 12 and relatively less light is extracted from the right side of the waveguide body 12.

In another embodiment, the lower surface 32 is textured. This texturing may be effected by a roughened surface that creates a diffusion effect, and/or by a plurality of extraction features 14. These extraction features 14 may be identical or similar to those described above.

Referring again to Figures 2 and 2A, in the illustrated case, the waveguide body 12 has a length L₁ parallel to the longitudinal axis L, the waveguide body 12 further has a width W transverse to the length L₁. The width W can be as little about 76 mm (3 inches) or as wide as manufacturing allows. In one case, the width W is about 305 mm (12 inches) and in another case the width W is about 610 mm (24 inches). The length L₁ can be as little as about 51 mm (2 inches) or as long as manufacturing allows. In one case, the length L₁ is preferably at least about 305 mm (12 inches), and, more preferably, at least about 1.22 m (48 inches). In the device shown in Figure 2, the waveguide disclosed herein may have the dimensions noted in the following table. It should be noted that the dimensions in the following table are exemplary only and not limiting:

**Table 2**

| Figure 2 | NOMINAL DIMENSION (Millimeters - unless otherwise specified) |
|---|---|
| A | 2.0 |
| B | 3.2 |
| C | 3.0 |
| D | 7.6 |
| E | 2.0 |
| F | 10 degrees |
| G | 300 |

As shown in Figure 3, the coupling portion 24 has a concave first surface 44 defining the cavity 29 and a curved V-shaped second surface 46 disposed opposite the concave first surface 44. The concave surface 44 may be textured so as to allow for better color mixing of the light, as shown in Figure 26. In one embodiment, the V-shaped second surface 46 is smooth and uncoated. In an alternative embodiment seen in Figure 6, an optional layer of specular material 48 is disposed on the V-shaped second surface 46. In still another version of the embodiment seen in Figure 6A, an optional specular reflective body 49 is located in the V-shaped convergence between the first and second sides 20, 22. The material 48 or the body 49 may be used in any of the embodiments discussed herein.

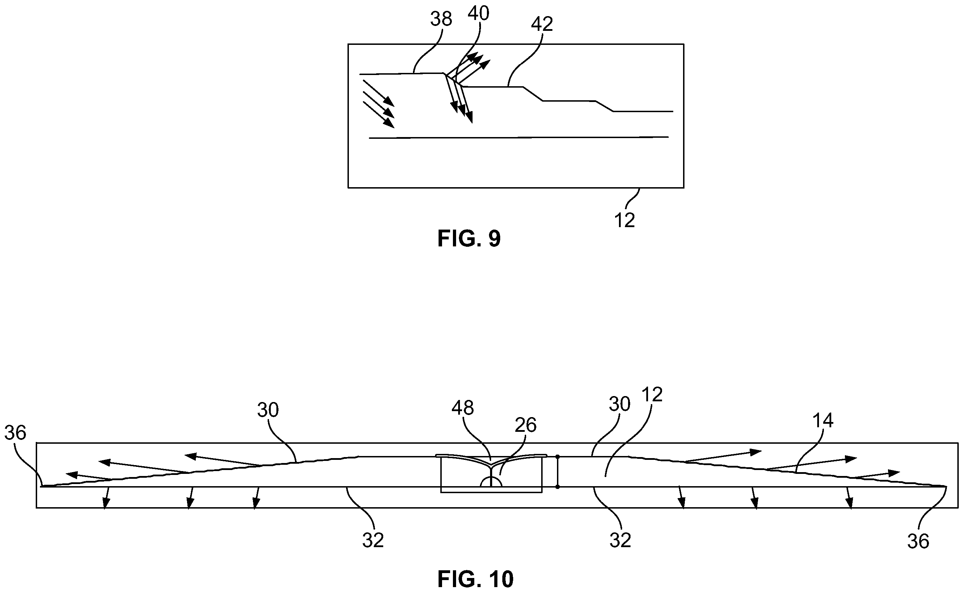

While redirecting rays of a light source 26 into one or more ray groups or beams each having a ray angle distribution range typically requires an optic substantially larger than the light source, such redirection can also be accomplished by using a thick waveguide 12, as shown in Figure 3A. However, it may be preferable for costs reasons to undertake such light redirection using a relatively thin waveguide. For example, as seen in Figure 3B, light developed by the light source 26 can be redirected into two independent sets of light rays. Each set of rays has a very narrow distribution range or may be substantially or fully collimated in order to achieve the desired light distribution out of the waveguide 12. Specifically, and with reference to Figure 6, the primarily Lambertian distribution of light developed by the LED element(s) 26 is incident on the walls defining the concave surface 44, and light incident on an upper surface 44a travels through the coupling portion 24 and strikes the curved V-shaped second surface 46. The surfaces 46a, 46b that make up the second surface 46 redirect the light by TIR (and/or specular reflection if the material 48 on the body 49 is present) into the sides 20, 22 as first sets of ray groups 51a, 51b that bounce due to total internal reflection between the upper and lower surfaces 30, 32 until such rays exceed the critical angle of the material of the waveguide body 12 and escape, as seen in Figures 7-9. Light incident on lower surfaces 44b travels through the coupling portion 24 directly into the portions 20, 22 without striking the curved V-shaped second surface 46. In the embodiment of Figure 3B the lower surfaces 44b are curved in a manner that causes the light passing through the surfaces 44b to be redirected second sets of ray groups 52a, 52b. This light also bounces between the upper and lower surfaces 30, 32 until such rays are below the critical angle of the material of the waveguide body 12 and escape, as also seen in Figures 7-9. In the illustrated embodiment of Figure 3B, the ray groups 51a and 52a have narrow ray angle distributions *(i.e.,* the ray groups are substantially or fully collimated). In some embodiments, the surfaces 46a, 46b may be parabolic in shape and centered on the light source 26. The extraction features 14 cause the light to exit the waveguide 12 in a controlled fashion such that light is directed out of the upper and lower surfaces 30, 32. Because the light rays are at least substantially collimated they experience minimal spreading as they propagate through the waveguide body 12. This results in highly controlled beams which can be either extracted in a collimated fashion, or spread into a wide distribution.

Specifically, as shown in Figures 6-8, the collimated light rays repeatedly bounce through the guide 12 by total internal reflection until they strike an extraction feature 14 and are redirected into the waveguide 12 or, if the angle of the light is below the critical angle, escape into the space or room to be illuminated. The light that strikes the extraction features 14 and is reflected back into the waveguide body 12 may strike the opposing waveguide body surface and escape out of the waveguide body 12 or may further reflect off the opposing surface and continue to travel within the waveguide body 12, depending upon the incident angle of the light striking such opposing surface. The light eventually leaves the waveguide body 12, preferably before reaching outer ends 20A, 22A. This escape is facilitated by the extraction features 14 which have stepped surfaces parallel to one another. This arrangement gives a tapered appearance to side sections 20, 22. The extracted light may have the light distribution illustrated in Figures 4A or 4J where the concentric circles mark the magnitude of intensity (candelas: lumens/steradian), and the lines extending radially from the center mark the angle of the exiting light with 0° pointing straight down, 90° to the right and 180° straight up. Any desired light distribution may be realized, however.

In an embodiment, extraction features 14 form an outwardly extending protrusion as shown in Figure 4D. The use of such an extraction feature 14 limits the distribution of light to either an upward or downward direction depending upon which surface of the waveguide body 12 the protrusions extend from. For example, an extraction feature 14 comprised of an outwardly extending protrusion, such as one in the shape of a dome, located on the upper surface of the waveguide body 12 as shown in Figure 4D would only allow light to emit in an upward direction. The opposite would be true if the outwardly protruding extraction features were located on the lower surface of the waveguide body 12. These extraction features 14 are particularly useful when combined with the coupling features discussed above.

In one case, the light produced from the LED 26 is reflected from a ceiling in an illuminance maximum to minimum ratio of no greater than about 4:1. More preferably, the light is reflected from the ceiling in an illuminance maximum to minimum ratio between about 1:1 to about 3:1. Most preferably, the light is reflected in an illuminance maximum to minimum ratio of no greater than about 2:1.

The illuminance obtained for the disclosed luminaire is such that, in one case, the use of the luminaire can result in a spacing criterion of about 1.3. In other words, a series of luminaires 10 could each be mounted 3.05 m (10 feet) apart at a height of 2.13 m (7 feet) above a surface to be illuminated and still achieve an acceptable level of luminance. An up-lighting spacing may range from a spacing criterion of 16 or lower. In other words, luminaires mounted 4.88 m (16 feet) apart at a distance of 305 mm (1 foot) from the ceiling will still achieve an acceptable level of illuminance and uniformity. The current arrangement has an upward spacing criterion of 10 or less. Down-light spacing may range from a spacing criterion of 2 or lower. At 4.88 m (16 feet) apart, luminaries may be mounted 2.44 m (8 feet) from the task surface and deliver the acceptable level of illuminance and uniformity. In one case, the luminaire may have a spacing criterion of 1.3 or less.

Figures 5A-5C, 10, and 29 illustrate an arrangement as assembled into a complete luminaire 60 suspended from a ceiling 62. A waveguide body 64 is disposed between end caps 66A, 66B that are, in turn, secured to a housing 68. The housing 68 encloses a driver circuit, although the driver circuit may be disposed at another location. Also, the housing 68 may be made of a thermally conductive material, such as aluminum, and may include heat dissipating structures 70 that radiate heat away from the driver circuit components. The housing 68 may be suspended by brackets 72 and wire rope 74 from appropriate ceiling mounting structures, as is conventional. The luminaire 60 may receive electrical power via an electrical connection cord 76.

The waveguide body 64 may be oriented in any direction (e.g., horizontally, vertically, or diagonally). As seen in Figures 5B and 5C, the waveguide body 64 is inverted (i.e., flipped over) relative to the waveguide body 12. Thus, a cavity 82 similar or identical to the cavity 29 of a coupling portion 84 that is similar or identical to the coupling portion 24 is disposed above a V-shaped curved surface 86 similar or identical to the V-shaped surface 46. As in the previous case, the V-shaped surface may be smooth and uncoated, or may be coated with a specular material or a specular reflective body may disposed adjacent and abutting the V-shaped surface 86 as in the previous case. LED element(s) (Figure 5C) 90 mounted on a substrate 92 may be secured relative to the waveguide body 64 such that the LED element(s) extend into the cavity 82. The waveguide body 64 otherwise differs from the waveguide body 12 in that side sections 90, 92 corresponding to the side sections 20, 22 are disposed substantially 180 degrees relative to one another, extraction features (not shown) similar or identical to any of the extraction features 14 disclosed herein are disposed in surfaces 96 adjacent the coupling portion 84, and surfaces 98 opposite the surfaces 96 have a greater lateral extent than the surfaces 96. The surfaces 96 are preferably smooth, although such surfaces may be textured as noted with respect to the surfaces 32.

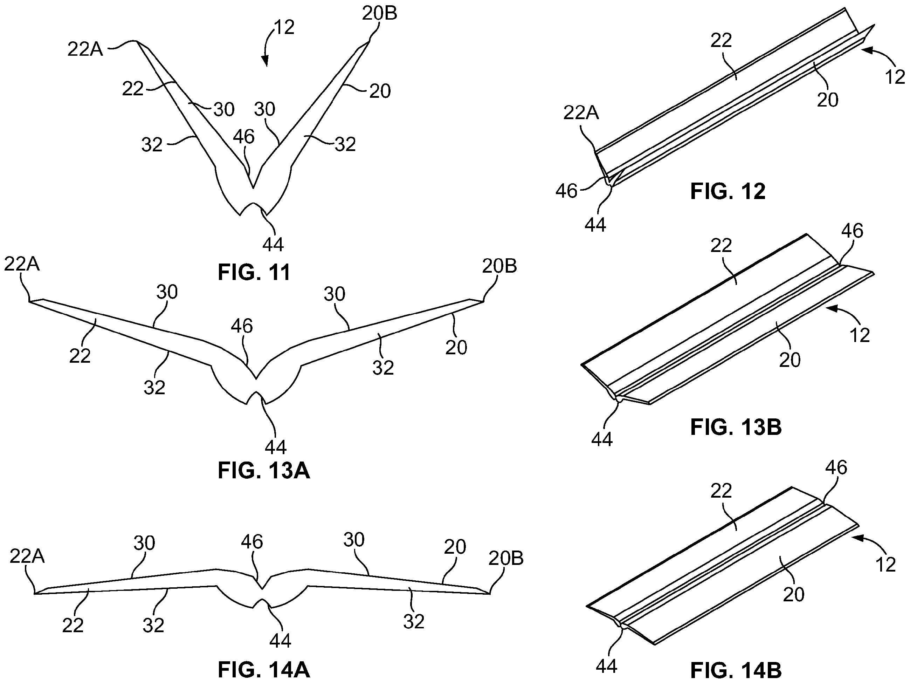

As shown in the various embodiments of the Figures, the lower surfaces 32 of the waveguide body 12 or 64 may be disposed at any angle A relative to an axis B (Figure 3) lying in a plane normal to the longitudinal axis L and bisecting the coupling portion 24. More preferably, this angle A is between about 45° and about 135° (see, e.g., Figures 11-14B). In another embodiment, the lower surface 32 is disposed at an angle A of between about 70° and about 90° relative to the axis B. In the arrangement illustrated in Figures 1-4, the lower surface 32 is disposed at an angle A of about 85° relative to the axis B.

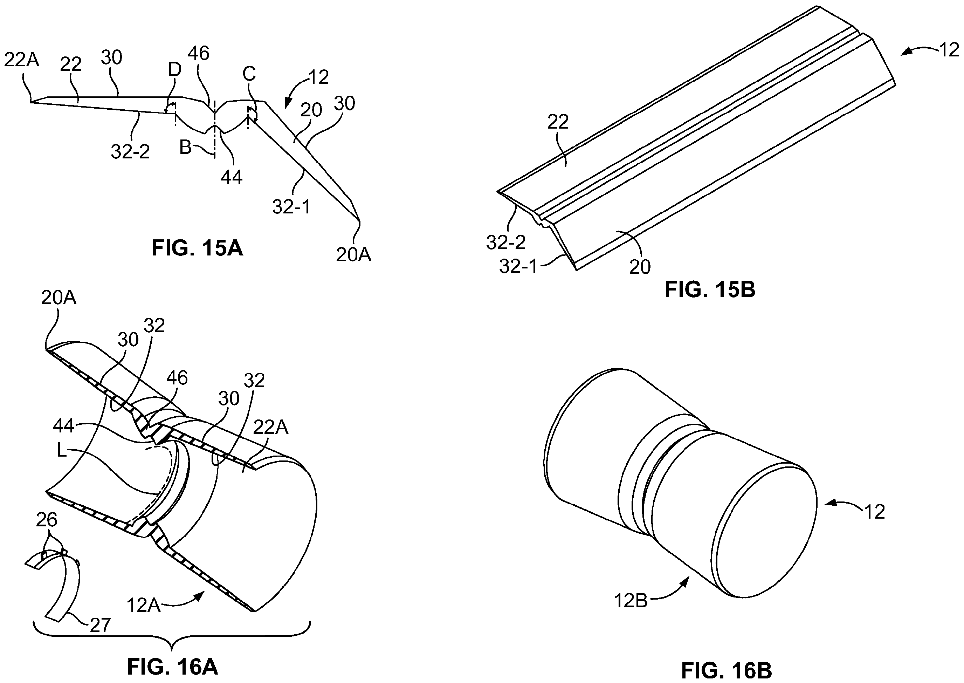

Figures 15A and 15B illustrate an embodiment in which the side sections 20, 22 are disposed at different angles, and hence, the embodiment is asymmetric. More particularly, lower surfaces 32-1 and 32-2 of the side sections 20, 22, respectively, form angles C and D, respectively, with respect to lines parallel to the axis B. In the preferred embodiment, the angles C and D are about 85 degrees and about 135 degrees, respectively, although these angles may have any magnitude. The embodiment of Figures 15A and 15B may have particular utility when used in a ceiling-suspended luminaire that is used adjacent an area where a wall meets the ceiling. In this case, the section 20 may be directed toward the intersection of the wall and ceiling such that the surface 30 illuminates such intersection and the inside of the room, and the section 22 may be directed away from such intersection to illuminate inner portions of the ceiling and the work spaces inside the room.

Referring next to Figures 16A and 16B, the waveguide body may be partially or fully curved to define a curved longitudinal axis L. For example, Figure 16A illustrates a waveguide body 12A that is partially curved about itself, but which is otherwise identical to the waveguide body 12 of any of the embodiments disclosed herein. The embodiment of Figure 16A is illustrated as being curved 180 degrees, although the waveguide body may be curved any other arcuate extent, as desired. Figure 16B illustrates an embodiment where a waveguide body 21B is fully curved about and joined to itself (i.e., the waveguide body is curved 360 degrees) to define a circular longitudinal axis L (not shown) and thereby form a circular cylinder. (It should be noted that Figure 16A also illustrates the waveguide body of Figure 16B in cross section). If desired, either of the waveguide bodies 12A, 12B may define other than a partial or full circle in a plane that includes the curved longitudinal axis L. Thus, for example, an ellipse or other shape may be defined. The waveguide body 21B may be otherwise identical to any of the embodiments disclosed herein and may be used in a luminaire. In such a case LED elements 26 may be disposed on a curved substrate 27 wherein the latter is secured to the waveguide body 12A, 12B in any suitable fashion such that the LED elements 26 extend into the cavity 29 defined by the surfaces 44.

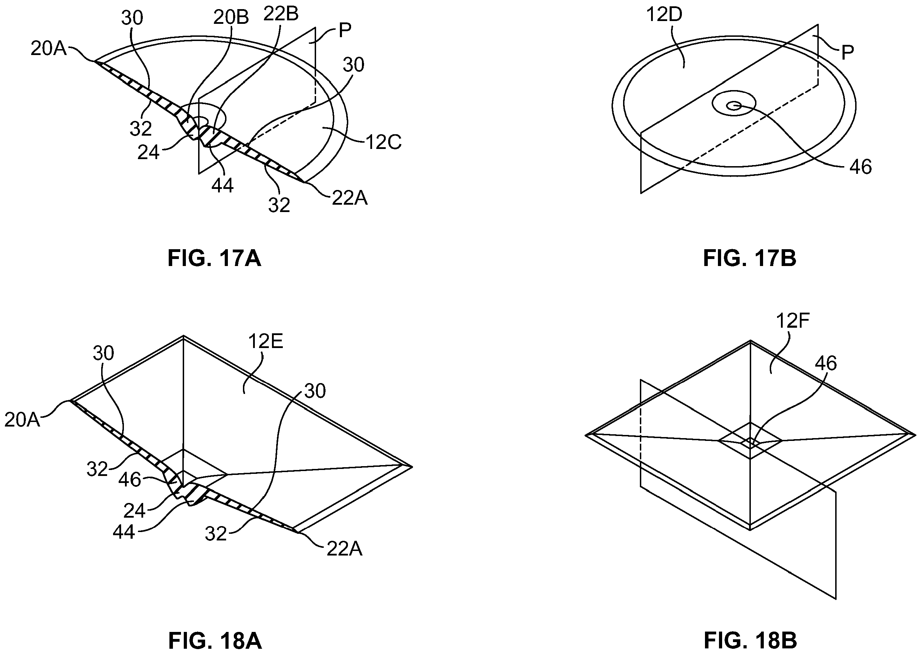

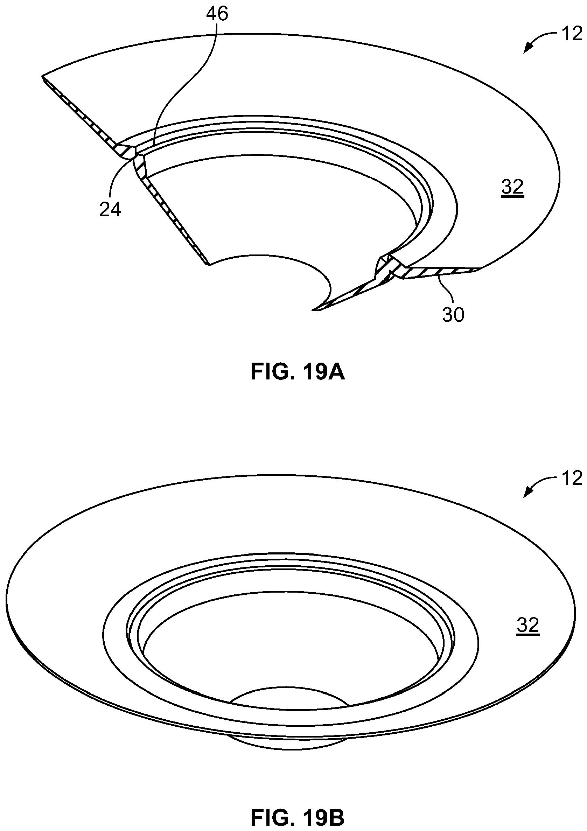

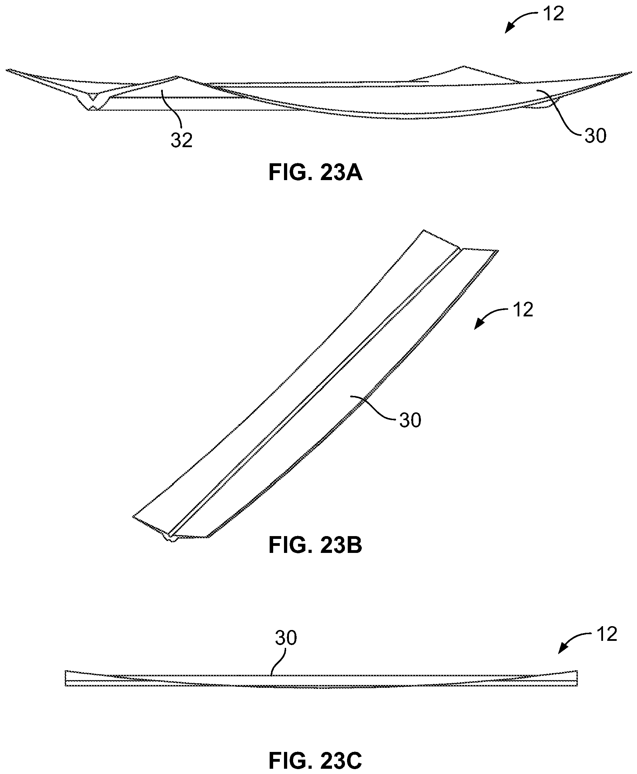

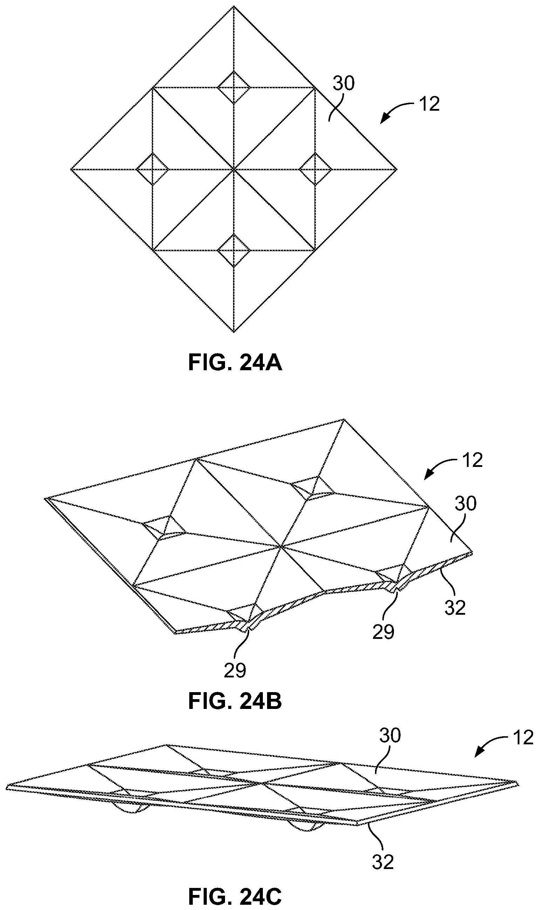

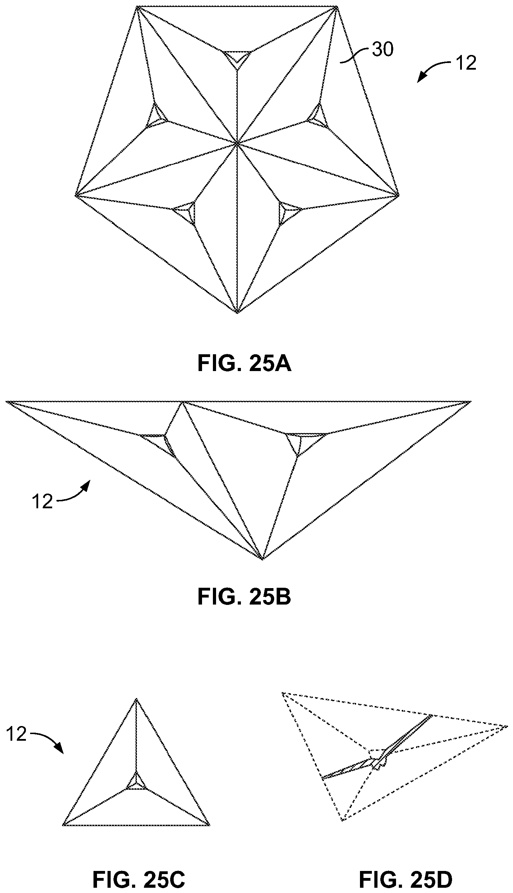

Figures 17A-20 and 23A-25D illustrate still further embodiments of waveguides that utilize the coupling portion 24 and the V-shaped surface 46. (As in the case of Figures 16A and 16B, Figures 17A and 18A not only illustrate alternative embodiments, but also show the embodiments of Figures 17B and 18B, respectively). The embodiments of these Figures are symmetric about a plane P (seen in Figures 17A and 17B) passing through the centers of the coupling sections and have a coupling portion 24 of limited size that can accommodate one or at most several LED elements. Figures 17A and 17B illustrate half and full circular waveguide bodies 12C, 12D, respectively, whereas Figures 18A and 18B depict half and full square waveguide bodies 12E, 12F, respectively. In the illustrated embodiments, the waveguide bodies 12C-12F have cross-sectional shapes similar or identical to the arrangements of Figures 1-4, although any of these embodiments may have a different cross-sectional shape, if desired. Other similar shapes are also possible, such as quarter circular or quarter square shapes, or shapes that are other than circular or square.

The alternate embodiments distribute light in the fashion noted in connection with Figures 1-3, and may be used in any luminaire, for example as disclosed herein, with suitable modifications as may be necessary or desirable to accommodate the different waveguide body shape. For example, any of the waveguide bodies disclosed herein may be used in the luminaire 60.

Figures 1, 2, and 2A also disclose a waveguide body 12 having a central section 18 and a first and a second separate side section 20, 22 that extend away from the central section 18 along first and second directions, respectively. The central section 18 includes a coupling portion 24 located in the central section 18.

In an embodiment, the waveguide body 12 includes a plurality of light extraction features 14 that extract out of the side sections 20, 22 of the waveguide body 12, emitted light generated by an LED light source proximal to the waveguide body 12. In another embodiment, each of the first and the second side sections 20, 22 has an upper and a lower surface 30, 32 and a first end 34 proximal to the coupling portion 24 and a second end 20A, 22A distal to the coupling portion 24. The first end 34 has a first thickness T₁, the second end has a second thickness T₂, and the first thickness T₁ is greater than the second thickness T₂. In a particular embodiment, for example, the first thickness T₁ is no greater than about 6 millimeters and the second thickness T₂ is no less than about 2 millimeters.

In still another embodiment, the coupling portion 24 of the waveguide body 12 curves upward towards the second end 20A.

In an embodiment, the upper surface 30 of the waveguide body 12 is textured. In a more particular embodiment, each of the plurality of light extraction features 14 is defined by a first surface 38, and an intermediate surface 40 extends from the first surface 38 to a second surface 42, as shown in Figures 4B, 4C, 4E, and 4G. All or some of the intermediate surfaces 40 may be planar or curved with each intermediate surface 40 having a curve of constant radius. In the latter case the surface 40 is preferably, although not necessarily, convex in cross section as seen in Figure 4C. In some embodiments, the surface 40 may include a planar portion as well as a curved portion as shown in Figure 4E. In other embodiments, all or some of the intermediate surfaces 40 may be scalloped as shown in Figure 4G, in combination with the planar or constant radius curvature noted above. Additionally, all or some of the intermediate surfaces 40 may be textured while both or one of the surfaces 38, 42 are smooth. Such texturing may be accomplished by cutting the surface with a polycrystalline diamond, or by any other suitable means. Surfaces 40 and/or extraction features 14 may be molded, embossed, or otherwise formed in one or both of the upper and lower surfaces 30, 32 of the waveguide 12. Alternatively, or in addition, a film (not shown) including extraction features may be adhered, laminated, or otherwise secured to one or both of the upper and lower surfaces 30, 32 to effectuate light extraction.

In the embodiments shown in Figures 4E, 4F, 4G, and 4H, the surface 40 disclosed herein may have the dimensions noted in the following table. It should be noted that the dimensions in the following table are exemplary only and not limiting:

**Table 3**

| | NOMINAL DIMENSION (Millimeters - unless otherwise specified) |
|---|---|
| Figure 4F | |
| H | 0.05 |
| I | 45 degrees |
| J | 0.005 (radius of curvature) |
| Figure 4H | |
| K | 0.340 |
| L | 27.5 degrees |
| M | 0.175 (radius of curvature) |
| Figure 4I | |
| N | 37.5 degrees |
| P | 0.050 |

In another embodiment, as seen in Figures 7 and 8, the intermediate surfaces 40 are planar, and the intermediate surfaces 40 are all parallel to one another, although the surfaces 40 need not all be planar or parallel. In another embodiment, the intermediate surfaces 40 are parallel to one another and are disposed at non-zero angles with respect to associated first and second surfaces 38, 40. The angle between each intermediate surface 40 and a line tangent to an adjacent associated surface 38 or 42 where the surface 38 or 42 meets the surface 40 may be relatively steep (for example, as seen in Figure 7) or may be relatively shallow (e.g., as seen in Figure 8). This angle (or any other related angle, such as the angle between the intermediate surface 40 and a line tangent to an adjacent associated surface 42 where the surface 42 meets the surface 40) and the size of each intermediate surface 40 affect the output distribution of light from the waveguide body 12.

In a more particular version of this embodiment, the first surface 38 is displaced from the second surface 42 by a particular distance and all of the distances between the first and the second surface of each of the plurality of light extraction features are equal. In a still more particular version of this embodiment, the intermediate surface 40 of each step of each of the plurality of extraction features 14 is angled at the same angle.

In one embodiment, the lower surfaces 32 of the first and the second side sections 20, 22 of the waveguide body 12 are textured. In a particular version of this embodiment, the lower surface 32 includes a plurality of extraction features 14, as discussed above.

As shown in Figure 3, the coupling portion 24 has a concave first surface 44 defining the cavity 29, and a curved V-shaped second surface 46 disposed opposite the concave first surface 44. The concave surface 44 may be textured so as to allow for better color mixing of the light. In one embodiment, the V-shaped second surface 46 is smooth and uncoated. In still another embodiment, the V-shaped second surface 46 may be a textured surface and, in a more particular embodiment, an optional layer of specular material 48 may be disposed on the V-shaped second surface 46, as shown in Figure 6.

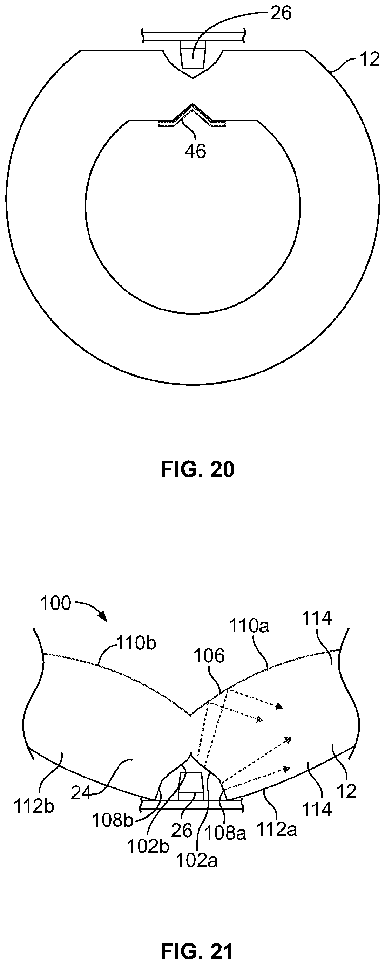

The concave first surface 44 may include both a curved and linear portion, as shown as 102 and 108 in Figure 21. Also, the surface of the central section 18 opposite the V-shaped second surface 46 may be curved in a gentle, parabolic manner as shown, for example in Figures 13A-15B and 21-22, in order to aid in collimating the reflected rays as the greater the curvature, the more collimated the rays. Referring to Figure 21, the first surface 44 includes curved and linear portions 102a, 108a opposite respective curved and linear portions 102b, 108b. Such surfaces 102a, 108a and respective 102b, 108b may be mirror images of one another or have different geometries.

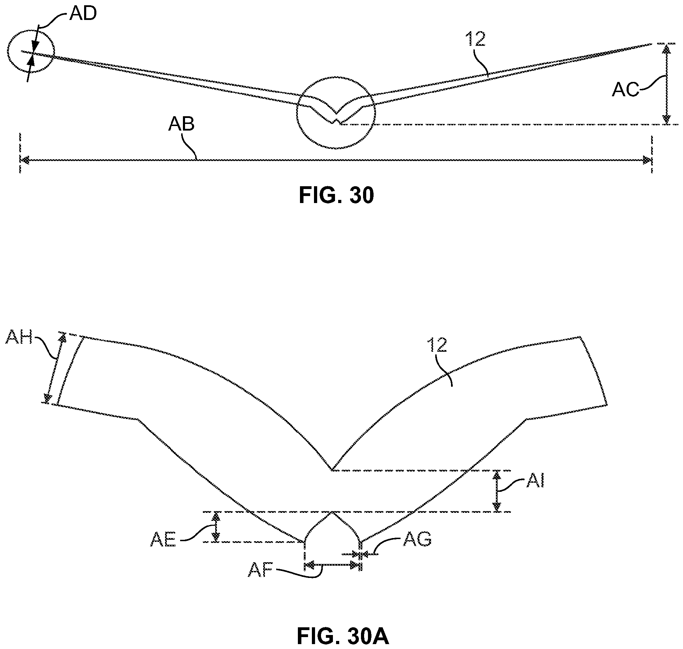

In the embodiments shown in Figures 30 and 30A, the waveguide 12 disclosed herein may have the dimensions noted in the following table. It should be noted that the dimensions in the following table are exemplary only and not limiting.

**Table 4**

| | NOMINAL DIMENSION (Millimeters - unless otherwise specified) |
|---|---|
| Figure 30A | |
| AB | 563.355 |
| AC | 66.338 |
| AD | 1.956 |
| Figure 30A | |
| AE | 2.850 |
| AF | 5.60 |
| AG | 0.20 |
| AH | 7.0 |
| AI | 3.965 |

In yet another embodiment, the waveguide body 12 may be made of a transparent acrylic.

Also disclosed is a coupling optic 100 for a waveguide body 12. As shown in Figure 21, the coupling optic 100 includes a first coupling section 102 disposed in an input region 104 of the coupling optic 100, a first reflection portion 106 remote from the input region 104 and adapted to reflect light entering the first coupling section 102 into the waveguide body 12, and a second coupling section 108 disposed at the input region 104 and distinct from the first coupling section 102 and adapted to refract light entering the second coupling section 102 directly into the waveguide body 12.

In an embodiment, the coupling optic 100 has a first surface 110 that curves outward from a center of the coupling portion 24, and a second surface 112 that curves outward from the center of the coupling portion 24 wherein the second surface 112 is opposite the first surface 110. In one embodiment, both or one of the first and second surfaces 110, 112 may be parabolic in shape and centered on the light source 26. In another embodiment, one or both of the first and second surfaces 110, 112 may be "free formed" in that it is specifically designed to control the angles of the light rays or the spread of the collimated group of rays that are directed through the waveguide 12. In other embodiments, one or both of the first and second surfaces 110, 112 may be a combination of a parabolic and free formed shape. Additionally, referring to Figure 21, the coupling optic 100 includes third and fourth surfaces 110b, 112b opposite respective first and second surfaces 110a, 112a. First and third surfaces 110a, 110b may be mirror images of each other or have different shapes. Similarly, second and fourth surfaces 112a, 112b may be mirror images of each other or have different shapes. The coupling optic 100 also has an end 114 distal to the center of the coupling portion 24, and a waveguide 12 is attached to the end 114. In a more specific version of the embodiment, the ends 114 of the first and second surfaces 110, 112 define a line that is approximately perpendicular to the first surface 110 and the second surface 112. Each of the first and second surfaces 110, 112 may be textured surfaces.

When in operation, the primarily Lambertian distribution of light emitted from the LED element(s) 26 travels through the first coupling section 102 where it then strikes the first reflection portion 106. The surface of the first coupling section 102 redirects the light by TIR toward the second surface 112 or into the waveguide 12 as one set of substantially collimated or parallel rays of light that bounce due to total internal reflection between the upper and lower surfaces of the waveguide 12 until such rays are below the critical angle of the material of the waveguide body 12 and escape.

Figures 28 and 28A illustrate an example not forming part of the invention, namely a waveguide 200 comprising a waveguide body 202 and a series of LEDs 26 of any suitable type, including the types disclosed herein, disposed on a surface 204 of a substrate 206. The surface 204 may be coated with a specular or white reflective surface. The waveguide body 202 includes a coupling portion 208 similar or identical to the coupling portion 24 disclosed above. The side sections of previous embodiments are replaced by a single light emitting section 204 that may include stepped (or other shaped) extraction features, as disclosed previously. As in other cases light rays may be arranged into groups wherein the light rays of each group travel at angles within a desired range of one another, within the TIR limits of the waveguide body material, so that the light rays undergo TIR at least once within the waveguide body.

### INDUSTRIAL APPLICABILITY

In summary, it has been found that when using a single color or multicolor LED element in a luminaire, it is desirable to mix the light output developed by the LEDs thoroughly so that the intensity and/or color appearance emitted by the luminaire is uniform. When the LED element is used with a waveguide, opportunities have been found to exist to accomplish such mixing during the light coupling and light guiding or distributing functions. Specifically, bending the light rays by refraction can result in improvement in mixing. In such a case, this refractive bending can be accomplished by providing interfaces in the waveguide between materials having different indices of refraction. These interfaces may define coupling features where light developed by the LED elements enters the waveguide and/or light redirection features at portions intermediate the coupling features and waveguide extraction features or areas where light is otherwise extracted (such as by bends) from the waveguide. It has further been found that directing light into a wide range of refraction angles enhances light mixing. Because the angle Aᵣ of a refracted light ray is a function of the angle Aᵢ between the incident light ray and the interface surface struck by the incident light ray (with refractive angle Aᵣ increasing as Aᵢ approaches zero, i.e., when the incident light ray approaches a parallel condition with respect to the interface surface), a wide range of refracted light ray angles can be obtained by configuring the interface surfaces to include a wide range of angles relative to the incident light rays. This, in turn, means that the interfaces could include a significant extent of interface surfaces that are nearly parallel to the incident light rays, as well as other surfaces disposed at other angles to the incident light rays. Overall waveguide shapes and coupling feature and redirection feature shapes such as curved (including convex, concave, and combinations of convex and concave surfaces), planar, non-planar, tapered, segmented, continuous or discontinuous surfaces, regular or irregular shaped surfaces, symmetric or asymmetric shapes, etc. can be used, it being understood that, in general, light mixing (consistent with the necessary control over light extraction) can be further improved by providing an increased number of interface surfaces and/or more complex interface shapes in the light path. Also, the spacing of coupling features and light redirection features affect the degree of mixing. In some embodiments a single light coupling feature and/or a single light redirection feature may be sufficient to accomplish a desired degree of light mixing. In other embodiments, multiple coupling features and/or multiple light redirection features might be used to realize a desired degree of mixing. In either event, the shapes of multiple coupling features or multiple redirection features may be simple or complex, they may be the same shape or of different shapes, they may be equally or unequally spaced, or distributed randomly or in one or more arrays (which may themselves be equally or unequally spaced, the same or different size and/or shape, etc.) Further, the interfaces may be disposed in a symmetric or asymmetric pattern in the waveguide, the waveguide itself may be symmetric or asymmetric, the waveguide may develop a light distribution that is symmetric, asymmetric, centered or non-centered with respect to the waveguide, and the light distribution may be on-axis (i.e., normal to a face of the waveguide) or off-axis (i.e., other than normal with respect to the waveguide face), single or split-beam, etc.

Still further, one or more coupling features or redirection features, or both, may be disposed anywhere inside the waveguide, at any outside surface of the waveguide, such as an edge surface or major face of the waveguide, and/or at locations extending over more than one surface or portion of the waveguide. Where a coupling or light redirection feature is disposed inside the waveguide, the feature may be disposed in or be defined by a cavity extending fully through the waveguide or in or by a cavity that does not extend fully through the waveguide (e.g., in a blind bore or in a cavity fully enclosed by the material of the waveguide). Also, the waveguide of any of the embodiments disclosed herein may be planar, non-planar, irregular-shaped, curved, other shapes, suspended, etc.

While specific coupling feature and light redirection feature parameters including shapes, sizes, locations, orientations relative to a light source, materials, etc. are disclosed as embodiments herein, the present invention is not limited to the disclosed embodiments, inasmuch as various combinations and all permutations of such parameters are also specifically contemplated herein. Thus, any one of the coupling cavities, redirection features, extraction features, etc. as described herein may be used in a luminaire, either alone or in combination with one or more additional elements, or in varying combination(s) to obtain light mixing and/or a desired light output distribution. Other luminaire and waveguide form factors than those disclosed herein are also contemplated.

The coupling features disclosed herein efficiently couple light into the waveguide, and the redirection features uniformly mix light within the waveguide and the light is thus conditioned for uniform extraction out of the waveguide. At least some of the luminaires disclosed herein are particularly adapted for use in installations, such as, replacement or retrofit lamps (e.g., LED PAR bulbs), outdoor products (e.g., streetlights, high-bay lights, canopy lights), and indoor products (e.g., downlights, troffers, a lay-in or drop-in application, a surface mount application onto a wall or ceiling, etc.) preferably requiring a total luminaire output of at least about 800 lumens or greater, and, more preferably, a total luminaire output of at least about 3000 lumens, and most preferably a total lumen output of about 10,000 lumens. Further, the luminaires disclosed herein preferably have a color temperature of between about 2500 degrees Kelvin and about 6200 degrees Kelvin, and more preferably between about 2500 degrees Kelvin and about 5000 degrees Kelvin, and most preferably about 2700 degrees Kelvin. Also, at least some of the luminaires disclosed herein preferably exhibit an efficacy of at least about 100 lumens per watt, and more preferably at least about 120 lumens per watt, and further exhibit a coupling efficiency of at least about 92 percent. Further, at least some of the luminaires disclosed herein preferably exhibit an overall efficiency (i.e., light extracted out of the waveguide divided by light injected into the waveguide) of at least about 85 percent. A color rendition index (CRI) of at least about 80 is preferably attained by at least some of the luminaires disclosed herein, with a CRI of at least about 88 being more preferable. A gamut area index (GAI) of at least about 65 is achievable. Any desired particular output light distribution, such as a butterfly light distribution, could be achieved, including up and down light distributions or up only or down only distributions, etc.

When one uses a relatively small light source which emits into a broad (e.g., Lambertian) angular distribution (common for LED-based light sources), the conservation of etendue, as generally understood in the art, requires an optical system having a large emission area to achieve a narrow (collimated) angular light distribution. In the case of parabolic reflectors, a large optic is thus generally required to achieve high levels of collimation. In order to achieve a large emission area in a more compact design, the prior art has relied on the use of Fresnel lenses, which utilize refractive optical surfaces to direct and collimate the light. Fresnel lenses, however, are generally planar in nature, and are therefore not well suited to re-directing high-angle light emitted by the source, leading to a loss in optical efficiency. In contrast, in the present invention, light is coupled into the optic, where primarily TIR is used for re-direction and collimation. This coupling allows the full range of angular emission from the source, including high-angle light, to be redirected and collimated, resulting in higher optical efficiency in a more compact form factor.

Embodiments disclosed herein are capable of complying with improved operational standards as compared to the prior art as follows:

| | State-of-the Art Standards | Improved Standards Achievable by Present Embodiments |
|---|---|---|
| Input (coupling + waveguide) | 90% | Almost 95%: improved through color mixing, source mixing, and control within the waveguide. |
| Output (extraction) | 90% | About 95%: improved through extraction efficiency. |
| Total system | ∼80% | About 90%: greater control, many choices |

In at least some of the present embodiments, the distribution and direction of light within the waveguide is better known, and hence, light is controlled and extracted in a more controlled fashion. In standard optical waveguides, light bounces back and forth through the waveguide. In the present embodiments, light is extracted as much as possible over one pass through the waveguide to minimize losses.

In some embodiments, one may wish to control the light rays such that at least some of the rays are collimated, but in the same or other embodiments, one may also wish to control other or all of the light rays to increase the angular dispersion thereof so that such light is not collimated. In some embodiments, one might wish to collimate to narrow ranges, while in other cases, one might wish to undertake the opposite.

The use of the terms "a" and "an" and "the" and similar reference in the context of describing the invention (especially in the context of the following claims) are to be construed to cover both the singular and the plural, unless otherwise indicated herein or clearly contradicted by context. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the disclosure and does not pose a limitation on the scope of the disclosure unless otherwise claimed. No language in the specification should be construed as indicating any non-claimed element as essential to the practice of the disclosure.

Preferred embodiments of this disclosure are described herein, including the best mode known to the inventors for carrying out the disclosure. It should be understood that the illustrated embodiments are exemplary only, and should not be taken as limiting the scope of the disclosure.

## Claims

1. A waveguide body comprised of a length from a first end to a second end, and further comprising:
a central section (18) extending along the entire length of the waveguide body and comprising a first thickness;
a first and a second separate and opposed side sections (20, 22), each of said side sections extending away from the central section (18) along first and second directions and along the length of the waveguide body and comprising second and third thicknesses, respectively; and
a coupling portion (24) located in the central section (18), wherein the coupling portion (24) comprises:
a concave first surface (44), the concave first surface (44) including first portions (102a, 108a) and second portions (102b, 108b), with first and second portions being opposite to each other and defining an elongate coupling cavity extending along the length of the waveguide body; and
a curved V-shaped second surface (46) comprising surfaces (46a, 46b) opposite the concave first surface (44), wherein the surfaces (46a, 46b) redirect light into the first and second side sections (20, 22), respectively,
**characterized in that** the coupling portion (24) further comprises lower surfaces (44b) that extend directly from the coupling cavity and are curved in a manner that cause light passing through the lower surfaces to be redirected into the first and second side sections (20, 22), respectively, and **in that** the side sections further comprise light extraction features (14) to extract light out of opposing surfaces (30, 32) of the side sections as the light propagates through the side sections.

2. The waveguide body of claim 1, wherein each side section (20, 22) comprises a plurality of light extraction features (14) that extract light out of the side sections (20, 22).

3. The waveguide body of claims 2, wherein each plurality of light extraction features protrudes outwardly from an associated one of the first and second side sections (20, 22).

4. The waveguide body of any of the preceding claims, wherein the opposing surfaces of the side sections comprise a first surface (30) and a second surface (32) opposite the first surface, and at least one of the first surface and the second surface is textured.

5. The waveguide body of any of the preceding claims, wherein a portion of the coupling cavity is concave and the surfaces (46a, 46b) of the curved V-shaped second surface (46) define a V-shaped surface located opposite the coupling cavity.

6. The waveguide body of claim 5, wherein the V-shaped surface is coated with a specular material (48).

7. The waveguide body of any of the preceding claims, wherein each of the surfaces (46a, 46b) of the curved V-shaped second surface (46) is configured to collimate a portion of light into at least one substantially collimated ray group that enters one of the first and second side sections (20, 22).

8. The waveguide body of any of the preceding claims, wherein the first and second side sections (20, 22) are asymmetric and the surfaces (46a, 46b) of the curved V-shaped second surface (46) are configured to direct light into the first and second side sections (20, 22).

9. The waveguide body of any of the preceding claims, wherein the light extraction features are spaced from the surfaces (46a, 46b) of the curved V-shaped second surface (46) to extract light out of said opposing surfaces of the first and second side sections (20, 22) as the light propagates through the side sections (20, 22).

10. The waveguide body of any of the preceding claims, wherein the first and second side sections (20, 22) further comprise first and second lower surfaces (32-1, 32-2) disposed at first and second side section angles (A) with respect to an axis (B) lying in a plane normal to a longitudinal axis of the central section (18), wherein the axis (B) further bisects the coupling portion (24).

11. The waveguide body of any of claims 1 to 9, wherein the first and second side sections (20, 22) further comprise first and second lower surfaces (32-1, 32-2) disposed at different side section angles (C, D) with respect to an axis (B) lying in a plane normal to a longitudinal axis of the central section (18), wherein the axis (B) further bisects the coupling portion (24).

12. The waveguide body of claim 11, wherein at least one of the surfaces (46a, 46b) of the curved V-shaped second surface (46) is configured to direct light into one of the first and second side sections (20, 22) as a substantially collimated ray group.

13. The waveguide body of claim 1, wherein each of the surfaces (46a, 46b) of the curved V-shaped second surface (46) is configured to direct light into one of the first and second side sections (20, 22).

14. The waveguide body of any of claims 1 to 9, wherein the first and second side sections (20, 22) further comprise first and second lower surfaces (32-1, 32-2) disposed at one of equal (A) and unequal (C, D) side section angles with respect to an axis (B) lying in a plane normal to a longitudinal axis of the central section (18), wherein the axis (B) further bisects the coupling portion (24). and wherein at least one of the first and second side section angles is one of: greater than about 45 degrees, less than about 90 degrees, greater than about 70 degrees, less than about 135 degrees, and between about 45 and about 135 degrees.

15. The waveguide body of claim 1, wherein at least one of said light extraction features (14) comprises a first surface (38), an intermediate surface (40), and a second surface (42), wherein the intermediate surface is disposed at non-zero angles to the first surface and the second surface, respectively.

16. The waveguide body of claim 1, wherein the light extraction features are disposed on an upper surface (30) of the first and second side sections.

## Patentansprüche

1. Wellenleiter-Körper, bestehend aus einer Länge von einem ersten Ende zu einem zweiten Ende und ferner umfassend:
einen zentralen Abschnitt (18), welcher sich entlang der gesamten Länge des Wellenleiter-Körpers erstreckt und eine erste Dicke umfasst;
einen ersten und einen zweiten separaten und gegenüberliegenden Seitenabschnitt (20, 22), wobei sich jeder der Seitenabschnitte weg von dem zentralen Abschnitt (18) entlang erster bzw. zweiter Richtungen und entlang der Länge des Wellenleiter-Körpers erstreckt und zweite bzw. dritte Dicken umfasst; und
einen Kopplungsteil (24), welcher in dem zentralen Abschnitt (18) platziert ist, wobei der Kopplungsteil (24) umfasst:
eine konkave erste Fläche (44), wobei die konkave erste Fläche (44) erste Teile (102a, 108a) und zweite Teile (102b, 108b) umfasst, wobei erste und zweite Teile einender gegenüberliegend sind und einen länglichen Kopplungshohlraum definieren, welcher sich entlang der Länge des Wellenleiter-Körpers erstreckt; und
eine gekrümmte, V-förmige zweite Fläche (46), welche Flächen (46a, 46b) gegenüber der konkaven ersten Fläche (44) umfasst, wobei die Flächen (46a, 46b) Licht in die ersten bzw. zweiten Seitenabschnitte (20, 22) umlenken, **dadurch gekennzeichnet, dass** der Kopplungsteil (24) ferner untere Flächen (44b) umfasst, welche sich direkt von dem Kopplungshohlraum erstrecken und in einer Weise gekrümmt sind, welche Licht, welches durch die unteren Flächen hindurchtritt, dazu veranlasst, in die ersten bzw. zweiten Seitenabschnitte (20, 22) umgelenkt zu werden, und dadurch dass die Seitenabschnitte ferner Licht-Extraktionsmerkmale (14) umfassen, um Licht aus gegenüberliegenden Flächen (30, 32) der Seitenabschnitte zu extrahieren, wenn das Licht durch die Seitenabschnitte propagiert.

2. Wellenleiter-Körper nach Anspruch 1, wobei jeder Seitenabschnitt (20, 22) eine Mehrzahl von Licht-Extraktionsmerkmalen (14) umfasst, welche Licht aus den Seitenabschnitten (20, 22) extrahieren.

3. Wellenleiter-Körper nach Anspruch 2, wobei jede Mehrzahl von Licht-Extraktionsmerkmalen nach außen von einem zugeordneten aus den ersten und zweiten Seitenabschnitten (20, 22) vorsteht.

4. Wellenleiter-Körper nach einem der vorhergehenden Ansprüche, wobei die gegenüberliegenden Flächen der Seitenabschnitte eine erste Fläche (30) und eine zweite Fläche (32) gegenüber der ersten Fläche umfassen, und wobei wenigstens eine aus der ersten Fläche und der zweiten Fläche texturiert ist.

5. Wellenleiter-Körper nach einem der vorhergehenden Ansprüche, wobei ein Teil des Kopplungshohlraums konkav ist und die Flächen (46a, 46b) der gekrümmten, V-förmigen zweiten Fläche (46) eine V-förmige Fläche definieren, welche gegenüber dem Kopplungshohlraum platziert ist.

6. Wellenleiter-Körper nach Anspruch 5, wobei die V-förmige Fläche mit einem spiegelnden Material (48) beschichtet ist.

7. Wellenleiter-Körper nach einem der vorhergehenden Ansprüche, wobei jede der Flächen (46a, 46b) der gekrümmten, V-förmigen zweiten Fläche (46) dazu eingerichtet ist, einen Teil von Licht in wenigstens eine im Wesentlichen kollimierte Strahlengruppe zu kollimieren, welche in einen aus den ersten und zweiten Seitenabschnitten (20, 22) eintritt.

8. Wellenleiter-Körper nach einem der vorhergehenden Ansprüche, wobei die ersten und zweiten Seitenabschnitte (20, 22) asymmetrisch sind und die Flächen (46a, 46b) der gekrümmten, V-förmigen zweiten Fläche (46) dazu eingerichtet sind, Licht in die ersten und zweiten Seitenabschnitte (20, 22) zu richten.

9. Wellenleiter-Körper nach einem der vorhergehenden Ansprüche, wobei die Licht-Extraktionsmerkmale von den Flächen (46a, 46b) der gekrümmten, V-förmigen zweiten Fläche (46) beabstandet sind, um Licht aus den gegenüberliegenden Flächen der ersten und zweiten Seitenabschnitte (20, 22) zu extrahieren, wenn das Licht durch die Seitenabschnitte (20, 22) propagiert.

10. Wellenleiter-Körper nach einem der vorhergehenden Ansprüche, wobei die ersten und zweiten Seitenabschnitte (20, 22) ferner erste und zweite untere Flächen (32-1, 32-2) umfassen, welche bei ersten und zweiten Seitenabschnitt-Winkeln (A) bezüglich einer Achse (B) angeordnet sind, welche in einer Ebene normal zu einer longitudinalen Achse des zentralen Abschnitts (18) liegt, wobei die Achse (B) ferner den Kopplungsabschnitt (24) schneidet.

11. Wellenleiter-Körper nach einem der Ansprüche 1 bis 9, wobei die ersten und zweiten Seitenabschnitte (20, 22) ferner erste und zweite untere Flächen (32-1, 32-2) umfassen, welche bei verschiedenen Seitenabschnitt-Winkeln (C, D) bezüglich einer Achse (B) angeordnet sind, welche in einer Ebene normal zu einer longitudinalen Achse des zentralen Abschnitts (18) liegt, wobei die Achse (B) ferner den Kopplungsabschnitt (24) schneidet.

12. Wellenleiter-Körper nach Anspruch 11, wobei wenigstens eine der Flächen (46a, 46b) der gekrümmten, V-förmigen zweiten Fläche (46) dazu eingerichtet ist, Licht in einen aus den ersten und zweiten Seitenabschnitten (20, 22) als eine im Wesentlichen kollimierte Strahlengruppe zu richten.

13. Wellenleiter-Körper nach Anspruch 1, wobei jede der Flächen (46a, 46b) der gekrümmten V-förmigen Fläche (46) dazu eingerichtet ist, Licht in einen aus den ersten und dem zweiten Seitenabschnitten (20, 22) zu richten.

14. Wellenleiter-Körper nach einem der Ansprüche 1 bis 9, wobei die ersten und zweiten Seitenabschnitte (20, 22) ferner erste und zweite untere Flächen (32-1, 32-2) umfassen, welche bei einem aus gleichen und ungleichen (C, D) Seitenabschnitt-Winkeln bezüglich einer Achse (B) angeordnet sind, welche in einer Ebene normal zu einer longitudinalen Achse des zentralen Abschnitts (18) liegt, wobei die Achse (B) ferner den Kopplungsabschnitt (24) schneidet,
und wobei wenigstens einer aus den ersten und zweiten Seitenabschnitt-Winkeln eines ist aus: größer als etwa 45 Grad, kleiner als etwa 90 Grad, größer als etwa 70 Grad, kleiner als etwa 135 Grad und zwischen etwa 45 Grad und etwa 135 Grad.

15. Wellenleiter-Körper nach Anspruch 1, wobei wenigstens eines der Lichtextraktions-Merkmale (14) ferner eine erste Fläche (38), eine Zwischenfläche (40) und eine zweite Fläche (42) umfasst, wobei die Zwischenfläche bei Winkeln ungleich null zu der ersten Fläche bzw. der zweiten Fläche angeordnet ist.

16. Wellenleiter-Körper nach Anspruch 1, wobei die Lichtextraktions-Merkmale an einer oberen Fläche (30) der ersten und zweiten Seitenabschnitte angeordnet sind.

## Revendications

1. Corps de guide d'ondes constitué d'une longueur allant d'une première extrémité à une seconde extrémité, et comprenant en outre :
une section centrale (18) s'étendant sur toute la longueur du corps de guide d'ondes et comprenant une première épaisseur ;
des première et seconde sections latérales distinctes et opposées (20, 22), chacune desdites sections latérales s'étendant en s'éloignant de la section centrale (18) dans des première et seconde directions et dans la longueur du corps de guide d'ondes et comprenant des deuxième et troisième épaisseurs, respectivement ; et
une partie de couplage (24) située dans la section centrale (18), dans lequel la partie de couplage (24) comprend :
une première surface concave (44), la première surface concave (44) comprenant des premières parties (102a, 108a) et des secondes parties (102b, 108b), les première et seconde parties étant opposées l'une à l'autre et définissant une cavité de couplage allongée s'étendant dans la longueur du corps de guide d'ondes ; et
une seconde surface incurvée en forme de V (46) comprenant des surfaces (46a, 46b) opposées à la première surface concave (44), dans lequel les surfaces (46a, 46b) redirigent de la lumière dans les première et seconde sections latérales (20, 22), respectivement,
**caractérisé en ce que** la partie de couplage (24) comprend en outre des surfaces inférieures (44b) qui s'étendent directement à partir de la cavité de couplage et sont incurvées d'une manière qui amène de la lumière passant à travers les surfaces inférieures à être redirigée dans les première et seconde sections latérales (20, 22), respectivement, et **en ce que** les sections latérales comprennent en outre des caractéristiques d'extraction de lumière (14) pour extraire de la lumière des surfaces opposées (30, 32) des sections latérales lorsque la lumière se propage à travers les sections latérales.

2. Corps de guide d'ondes selon la revendication 1, dans lequel chaque section latérale (20, 22) comprend une pluralité de caractéristiques d'extraction de lumière (14) qui extraient de la lumière des sections latérales (20, 22).

3. Corps de guide d'ondes selon la revendication 2, dans lequel chaque pluralité de caractéristiques d'extraction de lumière fait saillie vers l'extérieur depuis l'une associée des première et seconde sections latérales (20, 22).

4. Corps de guide d'onde selon l'une quelconque des revendications précédentes, dans lequel les surfaces opposées des sections latérales comprennent une première surface (30) et une seconde surface (32) opposée à la première surface, et au moins une parmi la première surface et la seconde surface est texturée.

5. Corps de guide d'onde selon l'une quelconque des revendications précédentes, dans lequel une partie de la cavité de couplage est concave et les surfaces (46a, 46b) de la seconde surface en forme de V incurvée (46) définissent une surface en forme de V située à l'opposé de la cavité de couplage.

6. Corps de guide d'ondes selon la revendication 5, dans lequel la surface en forme de V est revêtue d'un matériau spéculaire (48).

7. Corps de guide d'ondes selon l'une quelconque des revendications précédentes, dans lequel chacune des surfaces (46a, 46b) de la seconde surface en forme de V incurvée (46) est configurée pour collimater une partie de la lumière dans au moins un groupe de rayons sensiblement collimatés qui entre dans l'une des première et seconde sections latérales (20, 22).

8. Corps de guide d'ondes selon l'une quelconque des revendications précédentes, dans lequel les première et seconde sections latérales (20, 22) sont asymétriques et les surfaces (46a, 46b) de la seconde surface en forme de V incurvée (46) sont configurées pour diriger de la lumière dans les première et seconde sections latérales (20, 22).

9. Corps de guide d'ondes selon l'une quelconque des revendications précédentes, dans lequel les caractéristiques d'extraction de lumière sont espacées des surfaces (46a, 46b) de la seconde surface en forme de V incurvées (46) pour extraire de la lumière desdites surfaces opposées des première et seconde sections latérales (20, 22) lorsque la lumière se propage à travers les sections latérales (20, 22).

10. Corps de guide d'ondes selon l'une quelconque des revendications précédentes, dans lequel les première et seconde sections latérales (20, 22) comprennent en outre des première et seconde surfaces inférieures (32-1, 32-2) disposées à des premier et second angles de section latérale (A) par rapport à un axe (B) situé dans un plan perpendiculaire à un axe longitudinal de la section centrale (18), dans lequel l'axe (B) 13 bissecte en outre la partie de couplage (24).

11. Corps de guide d'ondes selon l'une quelconque des revendications 1 à 9, dans lequel les première et seconde sections latérales (20, 22) comprennent en outre des première et seconde surfaces inférieures (32-1, 32-2) disposées à des angles de section latérale différents (C, D) par rapport à un axe (B) situé dans un plan perpendiculaire à un axe longitudinal de la section centrale (18), dans lequel l'axe (B) bissecte en outre la partie de couplage (24).

12. Corps de guide d'onde selon la revendication 11, dans lequel au moins l'une des surfaces (46a, 46b) de la seconde surface en forme de V incurvée (46) est configurée pour diriger de la lumière dans l'une des première et seconde sections latérales (20, 22) sous la forme d'un groupe de rayons sensiblement collimatés.

13. Corps de guide d'ondes selon la revendication 1, dans lequel chacune des surfaces (46a, 46b) de la seconde surface en forme de V incurvée (46) est configurée pour diriger de la lumière dans l'une des première et seconde sections latérales (20, 22).

14. Corps de guide d'ondes selon l'une quelconque des revendications 1 à 9, dans lequel les première et seconde sections latérales (20, 22) comprennent en outre des première et seconde surfaces inférieures (32-1, 32-2) disposées selon un parmi des angles de section latérale égaux (A) et inégaux (C, D) par rapport à un axe (B) situé dans un plan perpendiculaire à un axe longitudinal de la section centrale (18), dans lequel l'axe (B) bissecte en outre la partie de couplage (24), et dans lequel au moins un parmi les premier et second angles de section latérale est un parmi : supérieur à environ 45 degrés, inférieur à environ 90 degrés, supérieur à environ 70 degrés, inférieur à environ 135 degrés, et entre environ 45 et environ 135 degrés.

15. Corps de guide d'ondes selon la revendication 1, dans lequel au moins l'une desdites caractéristiques d'extraction de lumière (14) comprend une première surface (38), une surface intermédiaire (40) et une seconde surface (42), dans lequel la surface intermédiaire est disposée à des angles non nuls par rapport à la première surface et à la seconde surface, respectivement.

16. Corps de guide d'ondes selon la revendication 1, dans lequel les caractéristiques d'extraction de lumière sont disposées sur une surface supérieure (30) des première et seconde sections latérales.
